(19) Europäisches Patentamt
European Patent Office
Office européen des brevets

(11) EP 2 550 710 B1

(12) EUROPÄISCHE PATENTSCHRIFT

(45) Veröffentlichungstag und Bekanntmachung des Hinweises auf die Patenterteilung:
**19.06.2019 Patentblatt 2019/25**

(21) Anmeldenummer: **11709148.8**

(22) Anmeldetag: **22.03.2011**

(51) Int Cl.:
**H01S 5/14** *(2006.01)*    **H01S 5/40** *(2006.01)*
**H01S 3/08** *(2006.01)*

(86) Internationale Anmeldenummer:
**PCT/EP2011/054377**

(87) Internationale Veröffentlichungsnummer:
**WO 2011/117257 (29.09.2011 Gazette 2011/39)**

(54) **LASERSYSTEM**

LASER SYSTEM

SYSTÈME LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.03.2010 DE 102010003227**

(43) Veröffentlichungstag der Anmeldung:
**30.01.2013 Patentblatt 2013/05**

(73) Patentinhaber: **UNIVERSITÄT STUTTGART INSTITUT FÜR STRAHLWERKZEUGE**
**70569 Stuttgart (DE)**

(72) Erfinder:
• **ABDOU AHMED, Marwan**
  **70569 Stuttgart (DE)**
• **VOSS, Andreas**
  **70563 Stuttgart (DE)**

(74) Vertreter: **Hoeger, Stellrecht & Partner Patentanwälte mbB**
**Uhlandstrasse 14c**
**70182 Stuttgart (DE)**

(56) Entgegenhaltungen:
**EP-A2- 0 709 938      EP-A2- 2 290 765**
**WO-A2-02/101895      US-A- 4 719 635**
**US-A- 5 715 263       US-A1- 2003 133 485**

**Beschreibung**

Die Erfindung betrifft ein Lasersystem umfassend mindestens einen extern stabilisierbaren Halbleiterlaser, aus dessen laseraktiver Zone ein Laserstrahlungsfeld auskoppelbar ist, ein extern im Laserstrahlungsfeld angeordnetes Rückkopplungselement, welches aus dem Laserstrahlungsfeld ein Rückkopplungsstrahlungsfeld mit definierter Wellenlänge und Bandbreite auskoppelt und in die laseraktive Zone zur Festlegung von Wellenlänge und Bandbreite des Laserstrahlungsfeldes zurückkoppelt.

Derartige Lasersysteme sind aus OPTICS LETTERS, August 15, 2004, Vol. 29, No. 16, Seite 1891-1893, von B.L. Voladin et. al. bekannt. Das bei diesen eingesetzte Volume Bragg grating ist aufgrund der eingesetzten speziellen Materialien sehr kostenintensiv.

Laserdioden, welche über ein externes Wellenleitergitter in ihrer Wellenlänge stabilisiert werden, sind z.B. aus EP 0 709 938 A2, US 4,719,635 A1 und WO 02/101895 A2 bekannt.

Der Erfindung liegt daher die Aufgabe zugrunde, ein Lasersystem der gattungsgemäßen Art derart zu verbessern, dass die Wellenlängenstabilisierung kostengünstiger realisierbar ist.

Die Aufgabe der Erfindung wird gelöst durch ein Lasersystem wie in Anspruch 1 definiert. Vorteilhafte Ausbildungsformen sind in den abhängigen Ansprüchen definiert.

Diese Aufgabe wird bei einem Lasersystem der eingangs beschriebenen Art erfindungsgemäß dadurch gelöst, dass das Rückkopplungselement ein einen innerhalb eines Winkelakzeptanzbereichs liegenden Teil des Laserstrahlungsfeldes zurückreflektierendes resonantes Wellenleitergitter ist.

Der Vorteil eines derartigen resonanten Wellenleitergitters ist der, dass dieses aufgrund der Tatsache, dass es resonant reflektiert, sehr schmalbandig ist und insbesondere sehr kostengünstig realisierbar ist und somit eine optimale Möglichkeit zur Festlegung der Wellenlänge des Laserstrahlungsfeldes darstellt.

Extern stabilisierbare Halbleiterlaser im Sinne der erfindungsgemäßen Lösung weisen eine austrittsseitige Rückreflexion von weniger als 30% auf. Besonders günstig extern stabilisierbar sind Halbleiterlaser mit einer austrittsseitigen Rückreflexion von weniger als 10%, noch besser weniger als 1%.

Das Rückkopplungselement ist ein resonantes Wellenleitergitter mit mindestens zweifacher Periodizität, das heißt ein resonantes Wellenleitergitter, dessen Strukturen keine einfache Periodizität, sondern eine mehrfache Periodizität aufweisen, da bei einem derartigen Wellenleitergitter bei geeigneter Auslegung der Winkelakzeptanzbereich vergrößert ist.

Besonders günstig ist es, wenn das resonante Wellenleitergitter einen Winkelakzeptanzbereich von mehr als ± 1° aufweist, noch vorteilhafter ist es, wenn das resonante Wellenleitergitter einen Winkelakzeptanzbereich von mehr als ± 2° aufweist.

Ferner ist vorzugsweise vorgesehen, dass die resonante Rückreflexion des Wellenleitergitters polarisationsabhängig ist, das heißt, dass lediglich eine Polarisationsrichtung resonant zurückreflektiert wird und die senkrecht dazu orientierte Polarisationsrichtung in Transmission das resonante Wellenleitergitter passiert.

Vorzugsweise ist dabei das resonante Wellenleitergitter so ausgebildet, dass es eine resonante Rückreflexionsrichtung aufweist, die parallel zur Einfallsrichtung des Laserstrahlungsfeldes, jedoch entgegengesetzt zu dieser verläuft. Ferner ist vorzugsweise vorgesehen, dass das resonante Wellenleitergitter im Resonanzwellenlängenbereich im Wesentlichen absorptionsfrei arbeitet.

Unter einem im Wesentlichen absorptionsfreien Arbeiten ist dabei zu verstehen, dass weniger als 5%, besser weniger als 1% und noch besser weniger als 0,5% der einfallenden Intensität absorbiert werden.

Hinsichtlich des Aufbaus des resonanten Wellenleitergitters wurden im Zusammenhang mit den bisherigen Ausführungsbeispielen keine näheren Angaben gemacht.

So sieht eine vorteilhafte Realisierungsform vor, dass das resonante Wellenleitergitter auf einem Substrat aufgetragene Wellenleiterschichten aufweist.

Ein derartiges Substrat kann beispielsweise aus Quarzglas, kristallinem Quarz, YAG, Saphir oder Diamant hergestellt sein.

Dabei wurde im Zusammenhang mit den mehreren Wellenleiterschichten nicht näher definiert, wie die Gitterstruktur vorgegeben sein soll.

Eine Lösung sieht dabei vor, dass eine Gitterstruktur durch eine die Wellenleiterschichten tragende Substratoberfläche vorgegeben ist.

Eine andere alternative Lösung hierzu sieht vor, dass die Gitterstruktur durch eine dem Substrat abgewandte oberste Wellenleiterschicht vorgegeben ist.

Dabei wurde die Zahl der Wellenleiterschichten im Zusammenhang mit den vorstehend beschriebenen Ausführungsbeispielen nicht näher spezifiziert.

Das resonante Wellenleitergitter ist aus mindestens drei Wellenleiterschichten aufgebaut, einer obersten Wellenleiterschicht mit einem hohen Brechungsindex, einer darunter liegenden Wellenleiterschicht mit einem niedrigeren Brechungsindex und einer der obersten Wellenleiterschicht gegenüberliegenden Wellenleiterschicht mit hohem Brechungsindex.

Die Wellenleiterschichten mit hohem Brechungsindex haben einen Brechungsindex im Bereich von 1,7 bis 3,5.

Die Wellenleiterschicht mit niedrigem Brechungsindex hat einen Brechungsindex im Bereich von 1,3 bis 1,6.

Es ist vorgesehen, dass die Differenz im Brechungsindex zwischen der Wellenleiterschicht mit hohem Brechungsindex und der Wellenleiterschicht mit niedrigem Brechungsindex mindestens 0,2 beträgt.

Vorzugsweise sind dabei die Brechungsindizes der obersten Wellenleiterschicht und der der obersten Wellenleiterschicht gegenüberliegenden Wellenleiterschicht näherungsweise identisch, insbesondere identisch.

Darüber hinaus wurden im Zusammenhang mit der bisherigen Erläuterung des resonanten Wellenleitergitters keine Angaben über den Verlauf der Wellenleiterschichten gemacht.

So sieht eine vorteilhafte Lösung vor, dass sich die Wellenleiterschichten des resonanten Wellenleitergitters in Ebenen erstrecken, die parallel zu einer quer zur Einfallsrichtung des Laserstrahlungsfeldes verlaufenden Querebene verlaufen.

Vorzugsweise ist dabei vorgesehen, dass sich die Wellenleiterschichten des Wellenleitergitters in Ebenen erstrecken, die parallel zu einer senkrecht zur Einfallsrichtung verlaufenden Querebene ausgerichtet sind.

Insbesondere ist dabei vorgesehen, dass sich das resonante Wellenleitergitter mit einer dem einfallenden Laserstrahlungsfeld zugewandten Seite quer zu einer Einfallsrichtung, vorzugsweise senkrecht zu der Einfallsrichtung, erstreckt.

Hinsichtlich der über die Reflexion des resonanten Wellenleitergitters hinausgehenden Eigenschaften desselben wurden bislang keine näheren Angaben gemacht.

So sieht eine vorteilhafte Ausführungsform eines resonanten Wellenleitergitters vor, dass dieses ein einfallendes Laserstrahlungsfeld teilweise in einer Wellenausbreitungsrichtung versetzt zurückreflektiert.

Eine derartige Wellenausbreitungsrichtung ist dabei insbesondere die Reihenrichtung, in welcher Erhebungen des resonanten Wellenleitergitters aufeinanderfolgend angeordnet sind, wobei die Erhebungen sich insbesondere quer zur Reihenrichtung erstrecken.

Vorzugsweise ist dabei vorgesehen, dass das resonante Wellenleitergitter eine Wellenausbreitungsrichtung aufweist, die parallel zu einer Streifenrichtung verläuft, in welcher sich das resonante Wellenleitergitter erstreckt.

Hinsichtlich eines Trägers für das resonante Wellenleitergitter wurden bislang keine näheren Angaben gemacht.

So sieht eine vorteilhafte Lösung vor, dass das resonante Wellenleitergitter auf einem für das Laserstrahlungsfeld im Wesentlichen transparenten Substrat angeordnet ist.

Das Substrat für das Wellenleitergitter kann dabei grundsätzlich ein beliebiges Substrat sein.

Um eine unerwünschte Erwärmung des resonanten Wellenleitergitters zu vermeiden, ist vorzugsweise vorgesehen, dass das resonante Wellenleitergitter kühlbar ist.

Als besonders vorteilhaft hat es sich erwiesen, wenn das resonante Wellenleitergitter auf einer für das Laserstrahlungsfeld transparenten Wärmesenke angeordnet ist.

Eine derartige transparente Wärmesenke, kann beispielsweise ein Träger für das Substrat oder auch ein Träger für das resonante Wellenleitergitter selbst sein.

Alternativ dazu ist es ebenfalls günstig, wenn die transparente Wärmesenke aus einem oder mehreren der Materialien wie kristallinem Quarz, YAG, Saphir und Diamant ist.

Hinsichtlich der Anordnung des resonanten Wellenleitergitters wurden im Zusammenhang mit der bisherigen Erläuterung der einzelnen Ausführungsformen keine Angaben gemacht.

Beispielsweise wäre es denkbar, das resonante Wellenleitergitter in einem divergenten Bereich des Laserstrahlungsfeldes anzuordnen.

In diesem Fall wäre jedoch die Anordnung des resonanten Wellenleitergitters aufgrund des begrenzten Winkelakzeptanzbereichs im divergenten Bereich nur in geringstem Abstand von einer Austrittsöffnung des Halbleiterlasers sinnvoll.

Aus diesem Grund ist vorzugsweise vorgesehen, dass das resonante Wellenleitergitter in einem zumindest teilkollimierten Bereich des Laserstrahlungsfeldes angeordnet ist, so dass bei korrekter Ausrichtung des Wellenleiters die Lage des resonanten Wellenleitergitters relativ zum Laserstrahlungsfeld keinen dominierenden Einfluss auf die Funktion des Lasersystems hat.

Alternativ dazu ist es aber auch denkbar, dass das resonante Wellenleitergitter in einem fokussierten Abschnitt des Laserstrahlungsfeldes, bei korrekter Abbildung angeordnet ist, so dass die Anordnung des resonanten Wellenleitergitters wenig winkelempfindlich ist.

Darüber hinaus könnte rein theoretisch das resonante Wellenleitergitter sich über den gesamten Strahlungsquerschnitt des Laserstrahlungsfeldes erstrecken, wobei in diesem Falle dann durch geeignete Polarisationswahl oder geeignete Divergenz oder Konvergenz des Laserstrahlungsfeldes die im Rücckopplungsstrahlungsfeld zurückreflektierte Intensität zu begrenzen ist.

Aus diesem Grund sieht ein besonders vorteilhaftes Ausführungsbeispiel eines erfindungsgemäßen Lasersystems vor, dass das resonante Wellenleitergitter in einem Teilbereich des Strahlungsquerschnitts des Laserstrahlungsfeldes angeordnet ist, so dass bereits durch Begrenzung des Teilbereichs des Strahlungsquerschnittes eine Begrenzung der Intensität des Rückkopplungsstrahlungsfeldes erfolgen kann.

Hinsichtlich des Verlaufs des resonanten Wellenleitergitters in dem Strahlungsquerschnitt wurden bislang keine näheren Angaben gemacht.

So sieht eine vorteilhafte Lösung vor, dass das resonante Wellenleitergitter sich streifenähnlich in einem Strahlungsquerschnitt des Laserstrahlungsfeldes erstreckt.

Dabei könnte das resonante Wellenleitergitter vollständig innerhalb des Strahlungsquerschnitts liegen.

Eine besonders günstige Lösung, die insbesondere die Kopplung mehrerer Laserstrahlungsfelder und somit auch mehrerer Halbleiterlaser erlaubt, sieht vor, dass das resonante Wellenleitergitter sich streifenähnlich innerhalb von mindestens zwei nebeneinanderliegenden Strahlungsquerschnitten von nebeneinanderliegenden Laserstrahlungsfeldern erstreckt.

Alternativ zum Vorsehen eines zusammenhängenden Wellenleitergitters, vorzugsweise in Form eines Streifens oder auch in einer anderen Form innerhalb des Strahlungsquerschnitts, sieht eine weitere vorteilhafte Lösung vor, dass das resonante Wellenleitergitter innerhalb des jeweiligen Strahlungsquerschnitts verteilt angeordnete Gitterflecken aufweist.

Derartige Gitterflecken sind vorzugsweise nicht zusammenhängende einzelne Wellenleitergitterteile an verschiedenen Stellen des Strahlungsquerschnitts, deren Wirkung insgesamt das Rückkopplungsstrahlungsfeld bildet, so dass das Austrittsstrahlungsfeld mehrere, jedoch kleinflächigere strahlungsfreie Bereiche aufweist, die dann im Fernfeld nicht ins Gewicht fallen.

Derartige Gitterflecken können dabei beispielsweise statistisch über den Strahlungsquerschnitt verteilt werden.

Eine zweckmäßige Lösung sieht jedoch vor, dass die Gitterflecken in im Abstand verlaufenden Reihenrichtungen angeordnet sind, so dass sich die Gitterflecken an definierten Stellen innerhalb des Strahlungsquerschnitts befinden.

Die Gitterflecken können dabei statistisch angeordnet sein. Eine andere Lösung sieht eine periodische Anordnung der Gitterflecken vor.

Hinsichtlich der Anordnung der Halbleiterlaser wurden bislang ebenfalls keine näheren Angaben gemacht.

So sieht eine vorteilhafte Ausführungsform vor, dass das Lasersystem mehrere in einem Halbleiterlaserbarren in einer Reihenrichtung aufeinanderfolgend angeordnete extern stabilisierbare Halbleiterlaser aufweist.

Derartige Halbleiterlaser sind dabei vorzugsweise so angeordnet, dass die Laserstrahlungsfelder in einer ersten Richtung parallel zu der Reihenrichtung die kleine Divergenz (slow axis) aufweisen.

Ferner sind die Halbleiterlaser vorzugsweise in dem Halbleiterlaserbarren so angeordnet, dass die Laserstrahlungsfelder in einer zweiten, quer zur Reihenrichtung verlaufenden Richtung die große Divergenz (fast axis) aufweisen.

Bei derartigen Halbleiterlaserbarren ist vorzugsweise vorgesehen, dass die in der Reihenrichtung aufeinanderfolgenden Halbleiterlaser Laserstrahlungsfelder erzeugen, die in einer parallel zur Reihenrichtung verlaufenden Richtung aufeinanderfolgend angeordnete Strahlungsquerschnitte aufweisen.

Ferner ist dann, wenn eine Kopplung der Laserstrahlungsfelder erfolgen soll, zweckmäßigerweise vorgesehen, dass sich das streifenförmig ausgebildete resonante Wellenleitergitter parallel zur Reihenrichtung innerhalb von mindestens zwei Strahlungsquerschnitten erstreckt, so dass die Halbleiterlaser miteinander koppelbar sind.

Dabei könnte das streifenförmig ausgebildete resonante Wellenleitergitter sich nur von einem Randbereich des einen Strahlungsquerschnitts zum Randbereich des anderen Strahlungsquerschnitts oder in einem Überlappungsbereich der Strahlungsquerschnitte erstrecken.

Es ist aber auch denkbar, dass sich das streifenförmig ausgebildete Wellenleitergitter über mehr als die Hälfte eines jeden der mindestens zwei Strahlungsquerschnitte erstreckt.

Eine besonders bevorzugte Lösung sieht vor, dass das resonante Wellenleitergitter in Richtung parallel zur Reihenrichtung einen durch alle Laserstrahlungsfelder des Halbleiterlaserbarrens verlaufenden Streifen bildet.

Beim Vorsehen von in Halbleiterlaserbarren angeordneten Halbleiterlasern ist vorzugsweise zum Vervielfachen der Zahl der Halbleiterlaser vorgesehen, dass die Halbleiterlaserbarren in einer Stapelrichtung aufeinander gestapelt angeordnet sind und somit in einer zweidimensionalen Fläche Austrittsöffnungen der Halbleiterlaser liegen.

Damit stehen noch mehr Halbleiterlaser zur Verfügung, so dass sich die zur Verfügung stehende Leistung steigern kann.

Hinsichtlich der Herstellung der Halbleiterlaser wurden bislang keine näheren Angaben gemacht.

Eine vorteilhafte Lösung sieht vor, dass in jedem der Halbleiterlaserbarren die Halbleiterlaser aus demselben Material hergestellt sind.

Eine derartige Lösung eröffnet die Möglichkeit, innerhalb des Halbleiterlaserbarrens die Halbleiterlaser aus demselben Material herzustellen.

Sollen alle Halbleiterlaser im selben Wellenlängenbereich arbeiten, so können alle Halbleiterlaserbarren auch aus demselben Material hergestellt werden.

Alternativ dazu ist es jedoch möglich, dass in unterschiedlichen Halbleiterlaserbarren die Halbleiterlaser aus unterschiedlichem Material hergestellt sind, so dass sich beispielsweise bereits aufgrund der Art des zur Herstellung verwendeten Materials auch der Wellenlängenbereich variieren lässt, in welchem die Halbleiterlaser stabilisierbar sind.

Hinsichtlich der Wellenlänge, auf welcher die Halbleiterlaser stabilisiert sind, sind die unterschiedlichsten Lösungen denkbar.

So sieht eine vorteilhafte Lösung vor, dass alle Halbleiterlaser bei derselben Wellenlänge stabilisiert sind.

Es kann aber auch bei anderen Anwendungen vorteilhaft sein, die Halbleiterlaser bei verschiedenen Wellenlängen extern zu stabilisieren.

Das heißt, dass beispielsweise die Möglichkeit besteht, die Halbleiterlaser in Gruppen aufzuteilen, wobei jede der Gruppen bei einer bestimmten Wellenlänge extern stabilisiert ist, die sich von der Wellenlänge, bei der jeweils die anderen Gruppen stabilisiert sind, unterscheidet.

Es besteht aber auch erfindungsgemäß die Möglichkeit, dass jeder Halbleiterlaser des erfindungsgemäßen Lasersystems auf einer von den anderen Halbleiterlasern unterscheidenden Wellenlänge stabilisiert ist.

In diesem Fall ist somit konsequent der Gedanke der verschiedenen Wellenlängen fortgeführt, was den Vorteil hat, dass sich in diesem Fall die von den jeweiligen Halbleiterlasern erzeugten Laserstrahlungsfelder besonders einfach überlagern lassen.

Betrachtet man die vorstehend beschriebenen Konzepte mit unterschiedlichen Wellenlängen im Zusammenhang mit Halbleiterlaserbarren, so sind in den jeweiligen Halbleiterlaserbarren vorzugsweise die Halbleiterlaser auf unterschiedlichen Wellenlängen extern stabilisiert.

Dieses Konzept lässt sich noch weiter dahingehend fortsetzen, dass die Halbleiterlaser in unterschiedlichen Halbleiterlaserbarren bei Wellenlängen extern stabilisiert sind, die sich von denen der anderen Halbleiterlaserbarren unterscheiden.

Weitere Merkmale und Vorteile der erfindungsgemäßen Lösung sind Gegenstand der nachfolgenden Beschreibung sowie der zeichnerischen Darstellung einiger Ausführungsbeispiele.

In der Zeichnung zeigen:

Fig. 1 eine schematische Seitenansicht eines ersten Ausführungsbeispiels eines erfindungsgemäßen Lasersystems;

Fig. 2 einen Schnitt längs Linie 2-2 in Fig. 1;

Fig. 3 eine Draufsicht von Oben in Richtung des Pfeils A in Fig. 1 auf das erste Ausführungsbeispiel des erfindungsgemäßen Lasersystems;

Fig. 4 einen Schnitt längs Linie 4-4 in Fig. 1;

Fig. 5 einen Querschnitt durch eine erste Variante eines erfindungsgemäßen resonanten Wellenleitergitters;

Fig. 6 eine Darstellung der Winkelakzeptanz der ersten Variante des erfindungsgemäßen Wellenleitergitters;

Fig. 7 eine Darstellung der Winkelakzeptanz eines erfindungsgemäßen Wellenleitergitters mit einfacher Periodizität;

Fig. 8 einen Schnitt ähnlich Fig. 5 durch eine zweite Variante eines erfindungsgemäßen Wellenleitergitters;

Fig. 9 eine vergrößerte Darstellung der zweiten Variante des erfindungsgemäßen Wellenleitergitters;

Fig. 10 einen Längsschnitt ähnlich Fig. 8 durch ein streifenförmig ausgebildetes in einer Reihenrichtung langgezogenes erfindungsgemäßes Wellenleitergitter;

Fig. 11 eine perspektivische Ansicht eines zweiten Ausführungsbeispiels eines erfindungsgemäßen Lasersystems;

Fig. 12 einen Schnitt längs Linie 12-12 in Fig. 11;

Fig. 13 einen Schnitt längs Linie 13-13 in Fig. 11;

Fig. 14 einen Schnitt ähnlich Fig. 13 durch ein drittes Ausführungsbeispiel eines erfindungsgemäßen Lasersystems;

Fig. 15 einen Teilschnitt ähnlich Fig. 1 durch ein viertes Ausführungsbeispiel eines erfindungsgemäßen Lasersystems;

Fig. 16 einen Schnitt ähnlich Fig. 15 durch ein fünftes Ausführungsbeispiel eines erfindungsgemäßen Lasersystems;

Fig. 17 einen Schnitt ähnlich Fig. 15 durch ein sechstes Ausführungsbeispiel eines erfindungsgemäßen Lasersystems;

Fig. 18 eine vergrößerte Darstellung einer kollimierenden Optik bei dem sechsten Ausführungsbeispiel des erfindungsgemäßen Lasersystems;

Fig. 19 eine Seitenansicht ähnlich Fig. 1 durch ein siebtes Ausführungsbeispiel eines erfindungsgemäßen Lasersystems;

Fig. 20 eine Draufsicht ähnlich Fig. 3 auf das siebte Ausführungsbeispiel des erfindungsgemäßen Lasersystems;

Fig. 21 einen Schnitt längs Linie 21-21 in Fig. 19;

Fig. 22 eine Darstellung ähnlich Fig. 13 durch ein achtes Ausführungsbeispiel eines erfindungsgemäßen Lasersystems;

Fig. 23 eine Seitenansicht ähnlich Fig. 1 durch ein neuntes Ausführungsbeispiel eines erfindungsgemäßen Lasersystems;

Fig. 24 einen Schnitt längs Linie 24-24 in Fig. 23;

Fig. 25 einen Schnitt ähnlich Fig. 24 durch ein Beispiel zum besseren Verständnis eines erfindungsgemäßen Lasersystems und

Fig. 26 ein Teilschnitt ähnlich Fig. 15 durch ein elftes Ausführungsbeispiel eines erfindungsgemäßen Lasersystems.

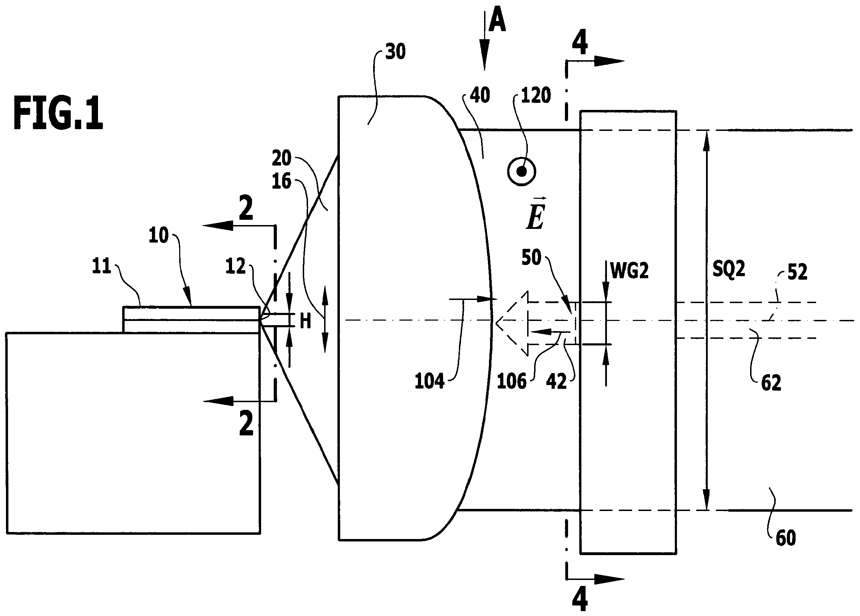

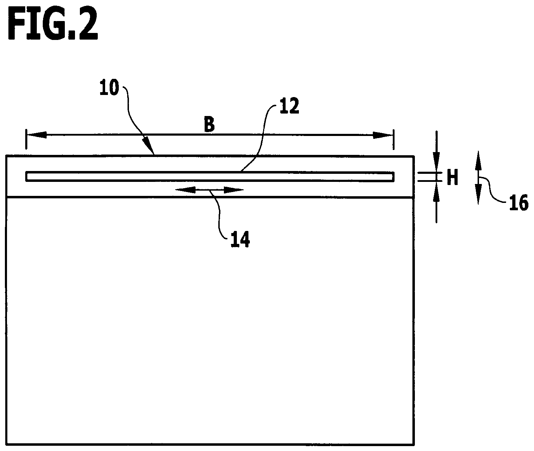

Ein in Fig. 1 dargestelltes Ausführungsbeispiel eines in Fig. 1 bis 3 dargestellten erfindungsgemäßen Lasersystems umfasst einen als Ganzes mit 10 bezeichneten Halbleiterlaser, mit einer laseraktiven Zone 11 aus deren Auskoppelöffnung 12 ein Laserstrahlungsfeld 20 austritt.

Die Auskoppelöffnung 12 erstreckt sich in einer ersten Richtung 14 über eine Breite B und in einer zweiten Richtung 16 über eine Höhe H, wobei die Breite B ein Vielfaches der Höhe H, vorzugsweise mindestens das 50-fache, vorzugsweise mindestens das 80-fache der Höhe H beträgt. Typische Werte der Auskoppelöffnung sind eine Breite B von 100 μm und eine Höhe H von 1 μm.

Das aus der Auskoppelöffnung 12 austretende Laserstrahlungsfeld 20 weist dabei in Richtung parallel zu der ersten Richtung 14 eine geringe Divergenz auf, die bei 95% Leistungsinhalt, weniger als 30°, vorzugsweise weniger als 15°, beträgt, während das Laserstrahlungsfeld 20 in Richtung parallel zu der zweiten Richtung 16 eine Divergenz aufweist, die bei 95% Leistungsinhalt mehr als 90° beträgt.

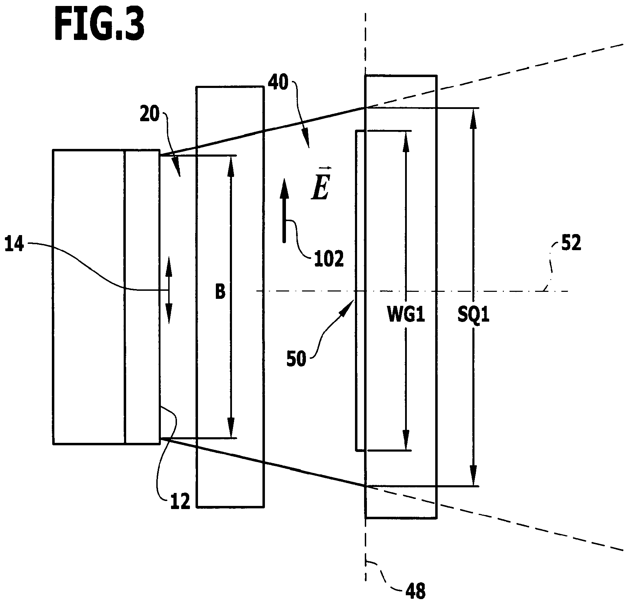

Dieses sowohl in Richtung parallel zu der ersten Richtung 14 als auch in Richtung parallel zu der zweiten Richtung 16 divergente Laserstrahlungsfeld 20 wird durch eine kollimierende Optik 30 hinsichtlich ihrer Divergenz in Richtung parallel zu der zweiten Richtung 16 kollimiert, so dass aus der kollimierenden Optik ein in der zweiten Richtung kollimiertes und somit insgesamt teilkollimiertes Strahlungsfeld 40 austritt, welches, wie in Fig. 3 dargestellt, in der ersten Richtung 14 dieselbe Divergenz aufweist, wie das Laserstrahlungsfeld 20.

Zur Stabilisierung des aus dem Halbleiterlaser 10 austretenden Laserstrahlungsfeldes 20 und des daraus gebildeten teilkollimierten Bereich 40 des Strahlungsfeldes 20 auf einer bestimmten Wellenlänge oder in einem bestimmten Wellenlängenbereich ist ein sich in einer Querebene 48 erstreckendes resonantes Wellenleitergitter 50 vorgesehen, welches sich, wie in Fig. 3 dargestellt, in der Querebene 48 parallel zu der ersten Richtung mit einer Ausdehnung WG1 erstreckt, welche mindestens 50% einer Ausdehnung SQ1 eines Strahlungsquerschnitts SQ in der Querebene 48 parallel zu der ersten Richtung 14 entspricht.

Vorzugsweise liegt die Ausdehnung WG1 im Bereich zwischen ungefähr 50% und ungefähr 80% der Ausdehnung SQ1 des Strahlungsquerschnitts SQ.

Ferner erstreckt sich das resonante Wellenleitergitter 50, wie in Fig. 1 dargestellt, mit einer Ausdehnung WG2 in der Querebene 48 parallel zu der zweiten Richtung 16, die mindestens 5%, maximal 30% der Ausdehnung SQ2 des Strahlquerschnitts SQ in der Querebene 48 parallel zu der zweiten Richtung 16 entspricht.

Ferner ist das resonante Wellenleitergitter 50 bezüglich einer senkrecht zu der Querebene 48 verlaufenden optischen Achse 52 sowohl parallel zur ersten Richtung 14 als auch parallel zur zweiten Richtung 16 symmetrisch zu dieser optischen Achse 52 angeordnet, welche jeweils eine Mittelachse der Laserstrahlungsfelder 20, 40 darstellt.

Das resonante Wellenleitergitter 50 dient dazu, einen Anteil im Bereich von 5% bis 30%, vorzugsweise im Bereich von 10% bis 20%, der Intensität des Laserstrahlungsfeldes 20, als Rückkopplungsstrahlungsfeld 42 in Richtung zur Halbleiterdiode 10 zurückzureflektieren, um die Laserbedingungen in der laseraktiven Zone 11 der Halbleiterdiode 10 bei einer definierten Wellenlänge oder in einem definierten Wellenlängenbereich zu stabilisieren, wobei nur ein geringer Teil der zurückreflektierten Intensität die laseraktive Zone 11 der Halbleiterdiode 10 erreicht.

Das heißt, dass die Ausdehnung des resonanten Wellenleitergitters 50, ausgehend davon, dass dieses in seinem Bereich in der Größenordnung von 100% der Intensität zurückreflektiert, so zu dimensionieren ist, dass dieses den vorstehend genannten Anteil der Intensität in die laseraktive Zone 11 des Halbleiterlasers 10 zurückreflektiert, während die im Übrigen nicht von dem resonanten Wellenleitergitter 50 zurückreflektierte Intensität des teilkollimierten Bereichs 40 des Laserstrahlungsfeldes 20 in Form eines Austrittsstrahlungsfeldes 60 zur Verfügung steht, wobei das Austrittsstrahlungsfeld 60 bedingt durch die Rückreflexion der Intensität im Bereich des resonanten Wellenleitergitters 50 zumindest unmittelbar nach dem resonanten Wellenleitergitter 50 einen intensitätsfreien Bereich 62 aufweist, welcher allerdings im Fernfeld aufgrund von Beugungseffekten an einer Außenkontur des resonanten Wellenleitergitters 50 weniger auffällig ist.

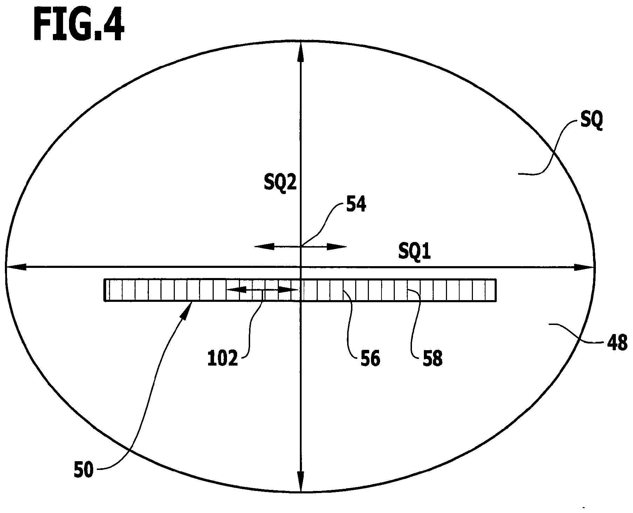

Bei dem ersten Ausführungsbeispiel des erfindungsgemäßen Lasersystems ist das resonante Wellenleitergitter 50, wie in Fig. 4 dargestellt, streifenförmig ausgebildet und erstreckt sich in einer Längsrichtung 54, während eine Gitterstruktur 56 quer zur Längsrichtung 54 ausgerichtete Strukturelemente 58 aufweist.

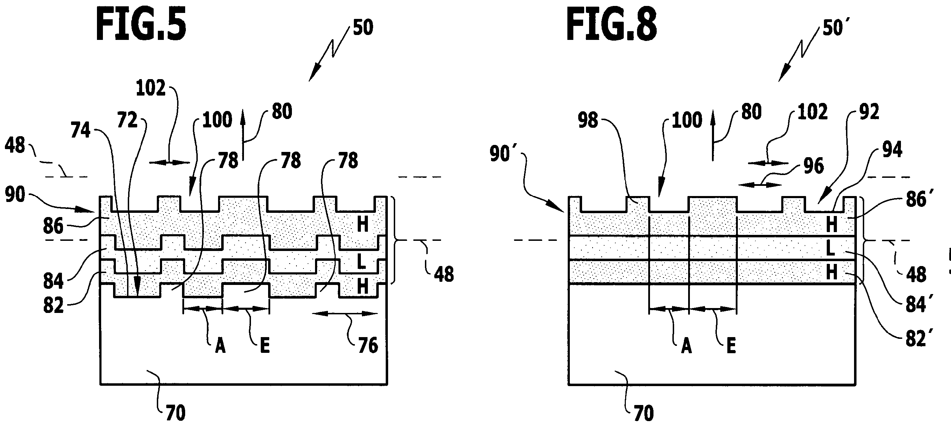

Wie beispielsweise in Fig. 5 dargestellt, umfasst eine erste Variante des resonanten Wellenleitergitters 50 ein Substrat 70 mit einer Oberflächenstruktur 72, welche über einer Basisfläche 74 in einer Reihenrichtung 76 aufeinanderfolgende Erhebungen 78 aufweist, wobei eine Ausdehnung E der Erhebungen 78 in der Reihenrichtung 76 sowie ein Abstand A zwischen den Erhebungen 78 eine Mehrfachperiodizität, d.h. mindestens eine zweifache Periodizität, aufweist, wobei sich die Erhebungen 78 quer zur Reihenrichtung 76 mit der gleichen Querschnittsfläche erstrecken.

Bei dem ersten Ausführungsbeispiel verläuft die Reihenrichtung 76 parallel zur Längsrichtung 54, so dass sich die Erhebungen 78 quer zur Längsrichtung 54 mit ihrem konstanten Querschnitt erstrecken.

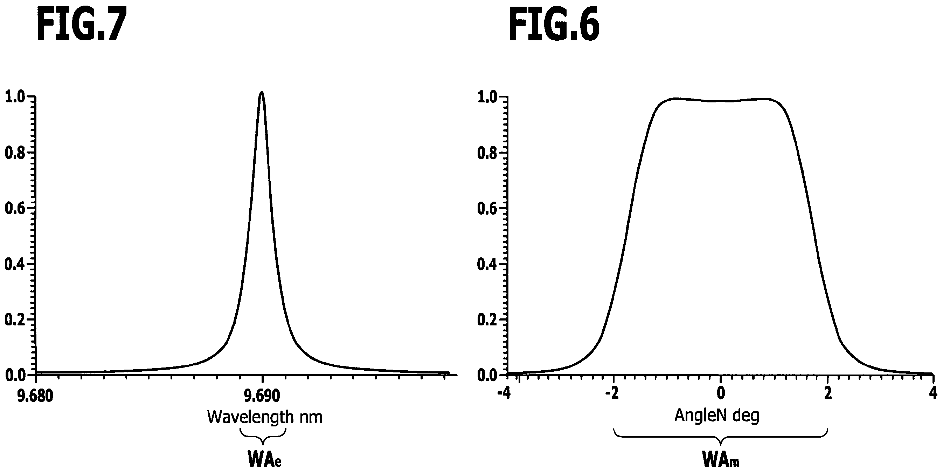

Auf der Oberflächenstruktur 72 des Substrats 70 ist bei dem ersten Ausführungsbeispiel des resonanten Wellenleitergitters 50 eine Schicht 82 mit höherem Brechungsindex, darauf eine Schicht 84 mit niedrigerem Brechungsindex und auf dieser wiederum eine Schicht 86 mit wiederum höherem Brechungsindex jeweils mit definierter Dicke aufgetragen, so dass sich die Oberflächenstruktur 72 des Substrats durch die Schichten 82, 84 und 86 hindurch fortsetzt, so dass die Schichten 82, 84 und 86 das resonante Wellenleitergitter mit mehrfacher Periodizität bilden. Ein derartiges resonantes Wellenleitergitter 50 mit mehrfacher Periodizität weist, wie in Fig. 6 dargestellt, in einer zur Reihenrichtung 76 parallelen Ebene für von einer Normalen 80 abweichend einfallende Strahlung einen verbreiterten Winkelakzeptanzbereich $WA_m$ auf, im Gegensatz zu einem Winkelakzeptanzbereich $WA_e$ eines in Fig. 7 dargestellten resonanten Wellenleitergitters mit einfacher Periodizität.

Der Winkelakzeptanzbereich ist dabei der Winkelbereich innerhalb von welchem 95 % der reflektierten Intensität liegen.

Die Schichten 82 und 86 mit höherem Brechungsindex sowie die Schicht 84 mit niedrigerem Brechungsindex erstrecken sich dabei parallel zu einer senkrecht zu der Normalen 80 verlaufenden Ebene 48 in welcher das resonante Wellenleitergitter 50 angeordnet ist.

Die in Fig. 6 dargestellte verbreiterte Winkelakzeptanzbereich $WA_m$ bedeutet, dass das resonante Wellenleitergitter 50 in der Lage ist, Strahlen vollständig zu reflektieren, die von der Normalen 80 auf dem resonanten Wellenleitergitter 50 um $\pm$ 2° abweichen.

Alternativ zu der ersten Variante des resonanten Wellenleitergitters 50, dargestellt in Fig. 5, ist, wie in Fig. 8 dargestellt, bei einer zweiten Variante des resonanten Wellenleitergitters 50' das Substrat 70 mit einer parallel zur Ebene 48 verlaufenden umstrukturierten Oberfläche versehen, auf welcher die Schicht 82' mit höherem Brechungsindex, Schicht 84' mit niedrigerem Brechungsindex und die Schicht 86' mit erneut höherem Brechungsindex angeordnet sind, wobei die Schicht 86' mit einer Oberflächenstruktur 92 versehen ist, die ebenfalls eine Basisfläche 94 und in einer Reihenrichtung 96 sich über die Basisfläche 94 heraushebende Erhebungen 98 aufweist, die insgesamt in der Reihenrichtung 96 aufeinanderfolgen und quer zur Reihenrichtung 26 eine konstante Querschnittsfläche aufweisen.

Dabei sind die Erhebungen 98 ebenfalls in Richtung der Reihenrichtung 96 mit einer Ausdehnung E versehen und zwischen den Erhebungen 98 liegen Abstände A, so dass sich durch die Oberflächenstruktur 92 sich ebenfalls eine Mehrfachperiodizität, vorzugsweise eine zweifache Periodizität ergibt, die ebenfalls zu der in Fig. 6 im Zusammenhang mit der ersten Variante erläuterten verbreiterten Winkelakzeptanz relativ zu der Normalen 80 führt.

Das Funktionsprinzip derartiger resonanter Wellenleitergitter ist in der Veröffentlichung von A. Avrutskii et. al. in Sov. I. Quantum Electron. 16(8) Aug. 1986, page 1063-1065, beschrieben.

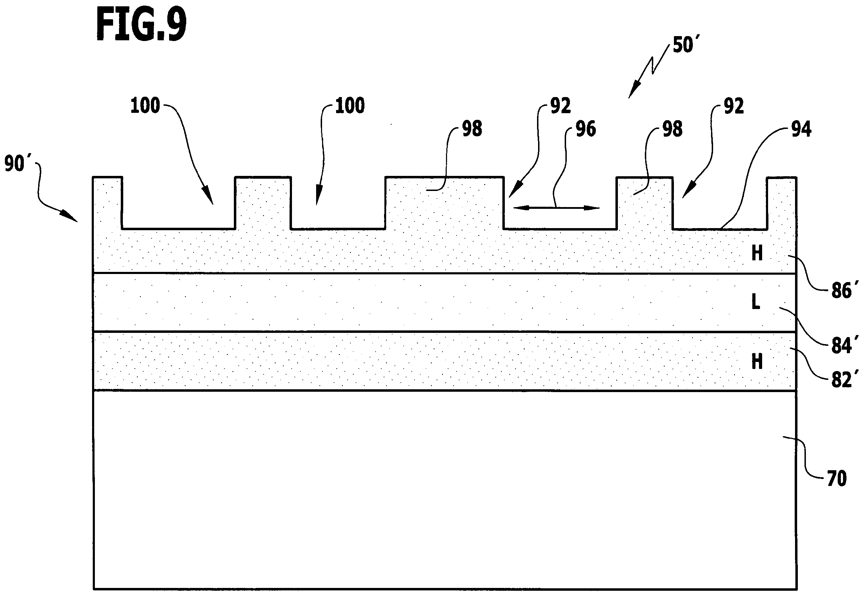

Aus Fig. 9 ergeben sich beispielhaft die Parameter, die für eine Wellenlänge von $\lambda$=969nm, die die Resonanzwellenlänge sein soll, bei der die gesamte Intensität von dem resonanten Wellenleitergitter 50' reflektiert wird, vorgesehen sind.

Weitere Angaben zu einem derartigen resonanten Wellenleitergitter finden sich in Sentenac et. al., JOSA A Vol.22, p. 475, 2005.

Für die Schichten 82 und 84 sind vorzugsweise Materialien wie $Ta_2O_5$, $HfO_2$, $Nb_2O_5$ oder auch $TiO_2$ oder $Si_3N_4$ vorgesehen.

Für die Schicht 84 kommen vorzugsweise Materialien wie $SiO_2$ in Frage.

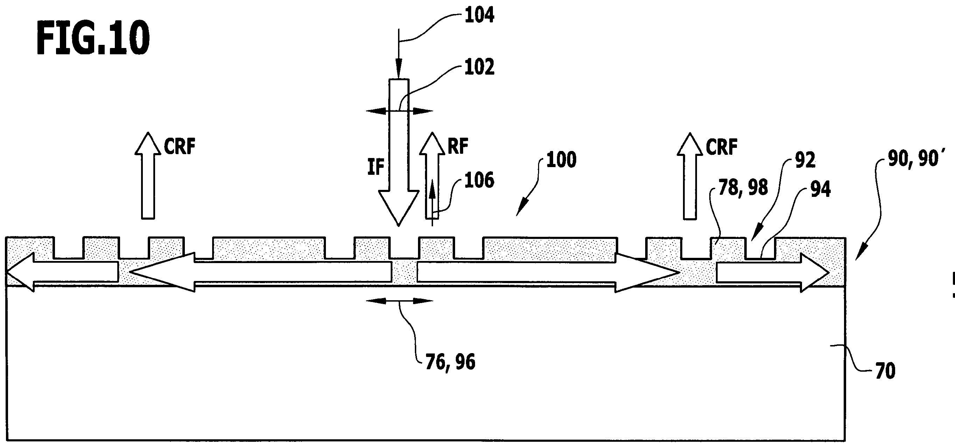

Das Grundprinzip derartiger resonanter Wellenleitergitter 50, 50' ist zusammengefasst das, dass auf eine dem Substrat 70 abgewandte Oberseite 100 mit einem die Polarisationsrichtung definierenden elektrischen Vektor 102 des elektrischen Feldes in einer Einfallsrichtung 104 auftreffende Strahlungsfelder IF dann, wenn diese im Resonanzwellenlängenbereich RW des resonanten Wellenleitergitters 50, 50' aufweisen, und der Vektor 102 des elektrischen Feldes parallel zur Reihenrichtung 76, 96 verläuft, vollständig von dem Schichtsystem 90 oder 90' in eine Rückreflexionsrichtung 106 reflektiert wird, wobei wie in Fig. 10 dargestellt, eine direkte Reflexion erfolgt, so dass das reflektierte Strahlungsfeld RF entsteht, und außerdem noch in dem Schichtsystem 90 oder 90' eine Wellenleitung in der Reihenrichtung 76, 96 erfolgt und in der Reihenrichtung 76, 96 versetzt eine Auskopplung von mit dem reflektierten Strahlungsfeld RF gekoppelten und sich in der Rückreflexionsrichtung 106 ausbreitenden reflektierten Strahlungsfeldern CRF erfolgt.

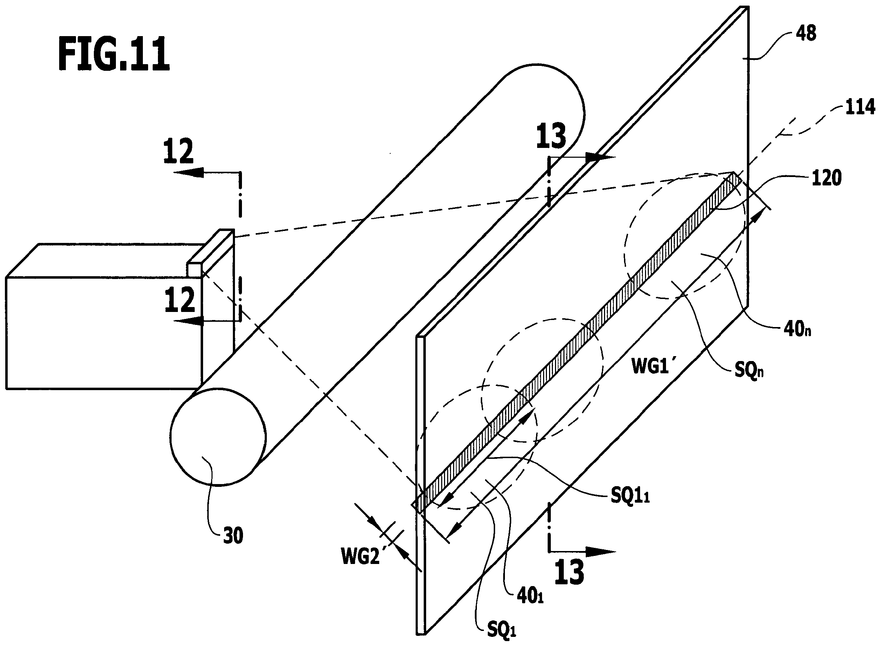

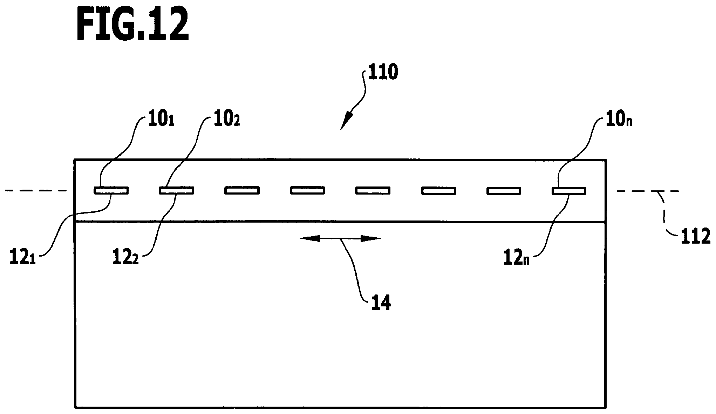

Bei einem zweiten Ausführungsbeispiel, dargestellt in Fig. 11 und Fig. 12, umfasst ein als Ganzes mit 110 bezeichneter Halbleiterlaserbarren eine Vielzahl von Halbleiterlasern $10_1$ bis $10_n$, die alle in einer zur ersten Richtung 14 parallelen Reihenrichtung 112 in einer Reihe im Abstand voneinander angeordnet sind und, wie in Fig. 11 dargestellt, teilkollimierte Bereiche $40_1$ bis $40_n$ der Laserstrahlungsfelder $20_1$ bis $20_n$ mit Strahlungsquerschnitten SQ erzeugen, die ebenfalls in der zur Reihenrichtung 112 parallelen Richtung 114 in einer zur Ebene 48 parallelen Ebene angeordnet sind, jedoch aufgrund der Divergenz in der ersten Richtung 14, die von der kollimierenden Optik 30 nicht kompensiert wird, miteinander überlappen, da die Ausdehnung SQ1 der Strahlungsquerschnitte SQ in der zur ersten Richtung parallelen Richtung 114 größer ist als der Abstand aufeinanderfolgender Auskoppelöffnungen $12_1$ bis $12_n$ in der Reihenrichtung 112 des Halbleiterlaserbarrens 110.

In der Ebene 48 liegt ebenfalls ein mit Grundstrukturen entsprechend einem der Wellenleitergitter 50, 50' versehenes streifenförmig ausgebildetes resonantes Wellenleitergitter 120, das sich parallel zur Richtung 114 durchgängig erstreckt und alle Strahlungsfeldquerschnitte $SQ_1$ bis $SQ_n$ durchsetzt.

Das resonante Wellenleitergitter 120 ist genauso aufgebaut wie das resonante Wellenleitergitter 50' und erstreckt sich allerdings mit der Reihenrichtung 96' durch alle Strahlungsquerschnitte SQ hindurch.

Ferner weist das streifenförmige resonante Wellenleitergitter 120 quer zur Richtung 114 eine Ausdehnung WG2' auf, die der Ausdehnung WG2 des ersten Ausführungsbeispiels entspricht, während die Ausdehnung WG1' des streifenförmigen resonanten Wellenleitergitters 120 einem Mehrfachen der Ausdehnung SQ1 der Strahlungsfeldquerschnitte SQ in der ersten Richtung 14 entspricht.

Das resonante Wellenleitergitter 120 bewirkt nun in jedem der kollimierten Laserstrahlungsfelder 20 eine Rückreflexion bei der vorgegebenen Resonanzwellenlänge, wie im Zusammenhang mit dem ersten Ausführungsbeispiel beschrieben.

Darüber hinaus erfolgt durch die begrenzte Wellenleitung bei der Resonanzwellenlänge RW in der Reihenrichtung 96 und der rückreflektierten Strahlungsfelder RF und CRF eine Kopplung der Laserstrahlungsfelder 40 der jeweils nebeneinanderliegenden Halbleiterlaser 10 untereinander, so dass dadurch insgesamt die

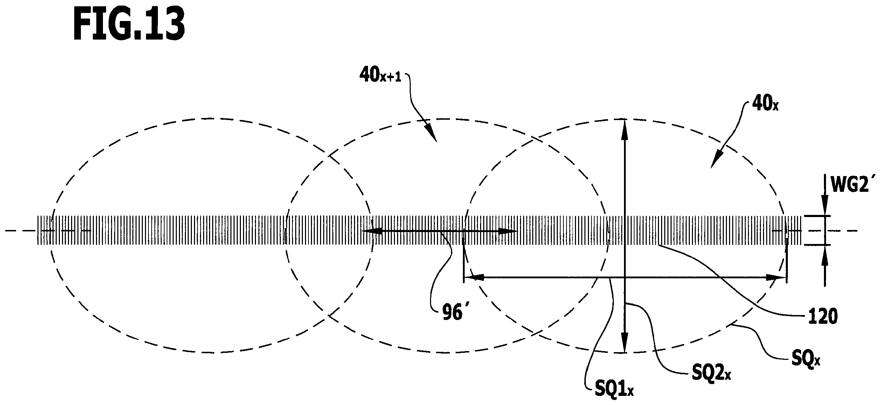

Halbleiterlaser $10_1$ bis $10_n$ des Laserbarrens 110 hinsichtlich der Wellenlänge, bei welcher diese bedingt durch das resonante Wellenleitergitter 120 arbeiten, miteinander gekoppelt sind, wie in Fig. 13 dargestellt.

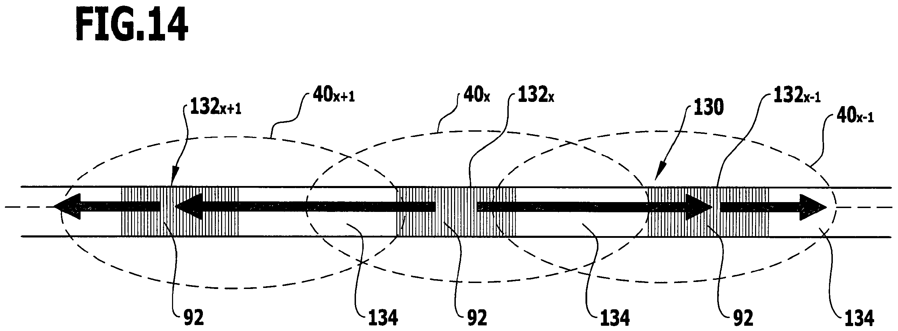

Bei einem in Fig. 14 dargestellten dritten Ausführungsbeispiel eines erfindungsgemäßen Lasersystems umfasst das resonante Wellenleitergitter 130 in gleicher Weise wie im Zusammenhang mit der Fig. 10 beim ersten Ausführungsbeispiel dargestellt, Bereiche 132 mit der Oberflächenstruktur 92 und Bereiche 134 ohne die Oberflächenstruktur 92, wobei aus den Bereichen 134 keine Einkopplung, Auskopplung und Rückreflexion des Strahlungsfeldes erfolgt, sondern nur in den Bereichen 132 mit der Oberflächenstruktur 92 sowohl eine Einkopplung als auch eine Auskopplung und Rückreflexion erfolgt.

Dies führt dazu, dass zwischen den Bereichen 132 beispielsweise durch Einkopplung von Laserstrahlung in den Bereich $132_x$ eine Kopplung zu den Bereichen $132_{x+1}$ und $132_{x-1}$ erfolgt, aus denen dann wiederum eine Auskopplung unter Rückreflexion der Laserstrahlung erfolgt. Werden nun die Bereiche $132_x$ so gelegt, dass sie jeweils ungefähr zentrisch zum entsprechenden Bereich 40 des Laserstrahlungsfeldes 20, beispielsweise zum Bereich $40_x$ Laserstrahlung einkoppelt und diese durch Wellenleitung zu den Bereichen $40_{x+1}$ und $40_{x-1}$ führt und dort reflektierend auskoppelt.

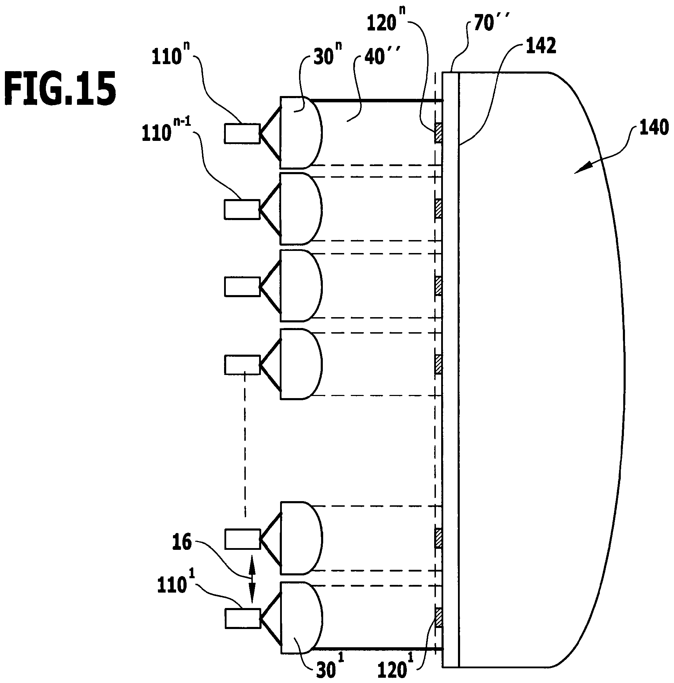

Bei einem vierten Ausführungsbeispiel einer erfindungsgemäßen Lasersystems, dargestellt in Fig. 15, sind eine Vielzahl von Laserbarren $110^1$ bis $110^n$ in Richtung der zweiten Richtung 16 übereinander angeordnet und für jeden der Laserbarren 110 ist eine eigene kollimierende Optik $30^1$ bis $30^n$ vorgesehen, so dass die teilkollimierten Bereiche 40 der Laserstrahlungsfelder in der zweiten Richtung 16 alle teilkollimiert sind und auf für jeden der Laserbarren 110 vorgesehene Wellenleitergitter $120^1$ bis $120^n$ auftreffen, die beispielsweise auf einem gemeinsamen Substrat 70" angeordnet sind, das seinerseits auf einer Rückseite 142 einer die teilkollimierten Bereiche 40" der Laserstrahlungsfelder 20 gemeinsam fokussierenden Optik 140 angeordnet ist, so dass das Substrat 70" durch die Optik 140 gehalten ist.

Damit werden in jedem der Laserbarren 110 sämtliche einzelnen Halbleiterlaser $10_1$ bis $10_n$ durch das jeweilige resonante Wellenleitergitter 120 gekoppelt, allerdings erfolgt keine Kopplung der teilkollimierten Bereiche 40 mit einem darüber liegenden oder darunter liegenden Laserbarren $110^{x+1}$ bzw. $110^{x-1}$.

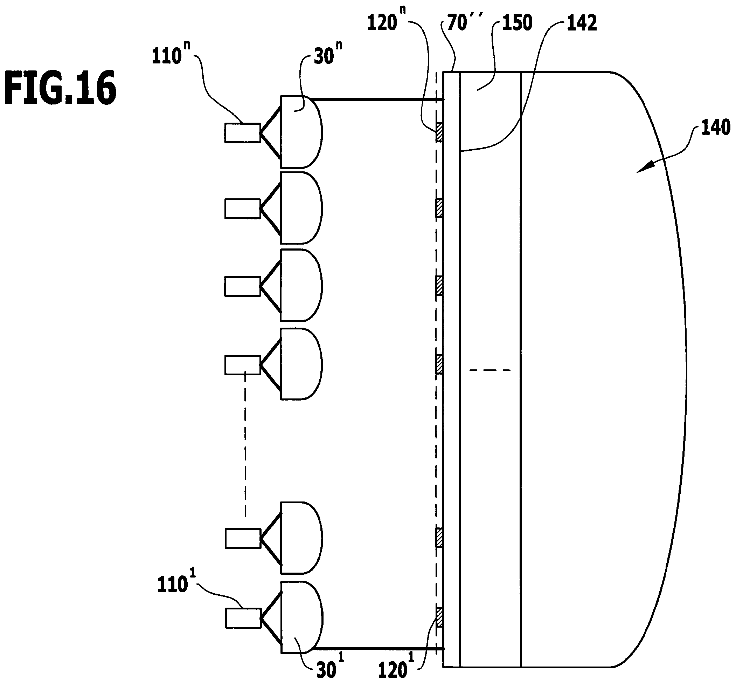

Alternativ zum vierten Ausführungsbeispiel ist bei einem fünften Ausführungsbeispiel, dargestellt in Fig. 16 auf der Rückseite 142 der Optik 140 nicht das Substrat 70 vorgesehen, sondern auf der Rückseite sitzt eine optisch transparente Wärmesenke 150, beispielsweise aus Saphir, welche ihrerseits auf ihrer den Laserbarren 110 zugewandten Seite das Substrat 70" mit den resonanten Wellenleitergittern 120 trägt.

Mit der Wärmesenke 150 ist es in einfacher Weise möglich, die in den resonanten Wellenleitergittern 120 entstehende Wärme optimal abzuführen und insbesondere die Wellenleitergitter 120 auf einer konstanten Betriebstemperatur zu halten, da auch die Betriebstemperatur sich auf die Resonanzwellenlänge auswirkt.

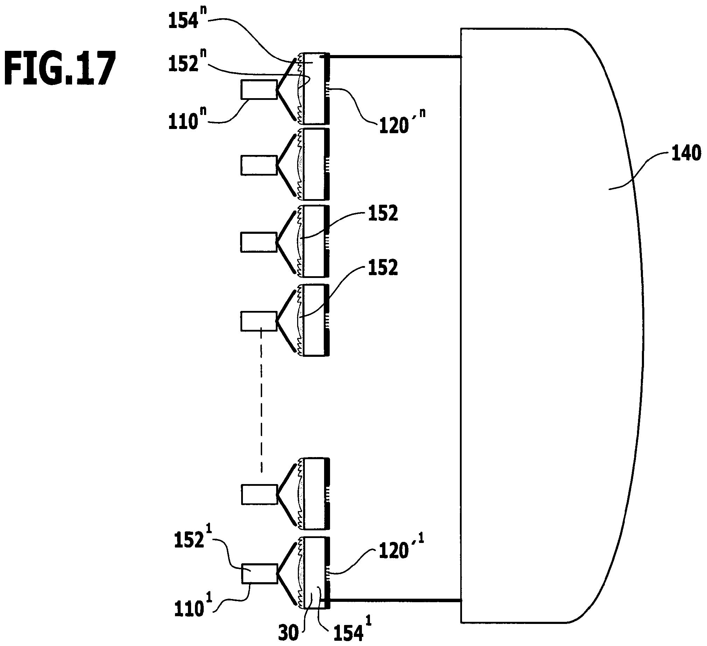

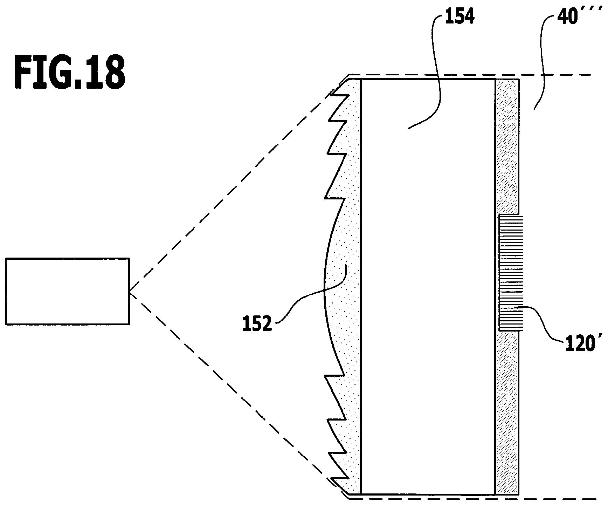

Bei einem sechsten Ausführungsbeispiel, dargestellt in Fig. 17 und 18, sind die kollimierenden Optiken $30'^1$ bis $30'^n$, gebildet aus einer Fresnellinse 152, die auf einer Seite einer optisch transparenten Wärmesenke 154 angeordnet ist und auf einer der Fresnellinse 152 gegenüberliegenden Seite der Wärmesenke 154 ist das dem jeweiligen Halbleiterlaserbarren $110^1$ bis $110^n$ zugeordnete Wellengitter $120'^1$ bis $120'^n$ angeordnet, da auf dieser Seite der Wärmesenke 154 bereits der kollimierte Bereich 40''' vorliegt.

Das jeweilige Wellenleitergitter $120'^1$ bis $120'^n$ ist entsprechend dem zweiten, dritten oder vierten Ausführungsbeispiel ausgebildet.

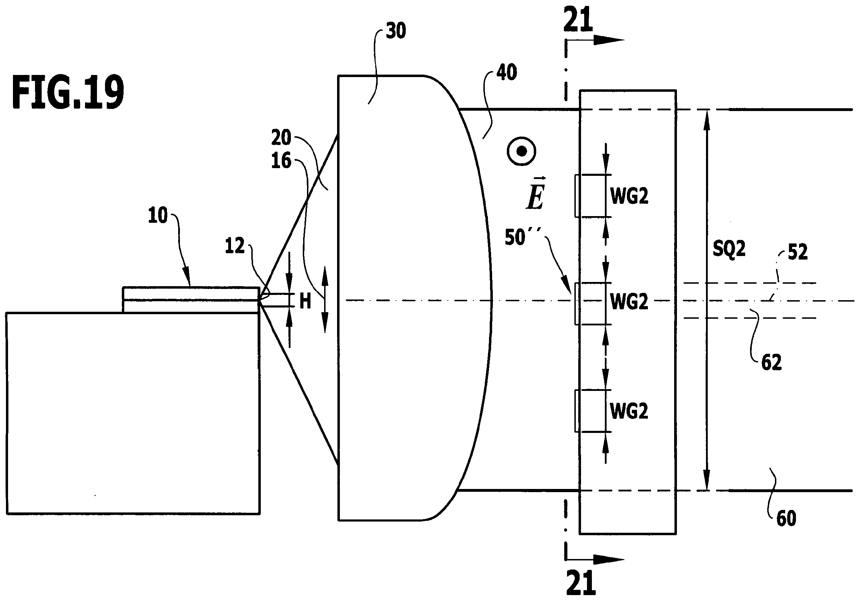

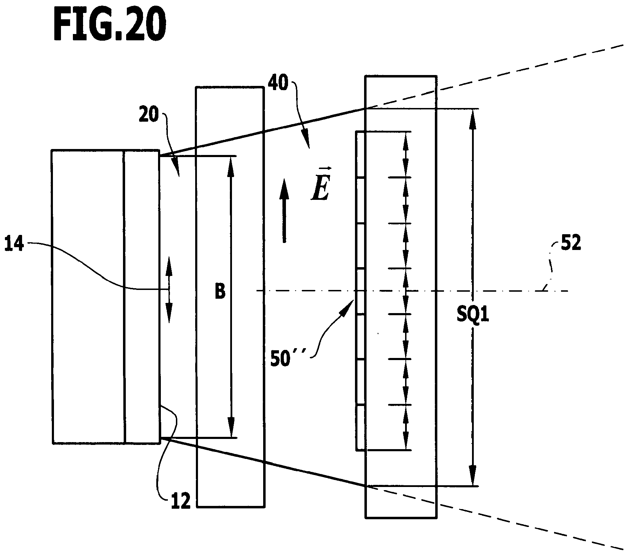

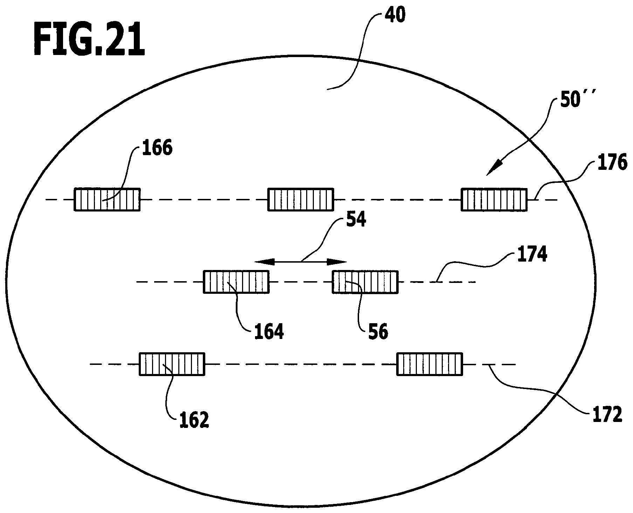

Im Gegensatz zu den voranstehenden Ausführungsbeispielen, bei denen jeweils davon ausgegangen wurde, dass ein zusammenhängendes streifenförmiges resonantes Wellenleitergitter 50, 120 zum Einsatz kommt, sieht ein siebtes, in den Fig. 19 bis 21 dargestelltes Ausführungsbeispiel vor, dass das Wellenleitergitter 50'', welches auf den teilkollimierten Bereich 40 reflektierend wirkt, aus einer Vielzahl von Gitterflecken 162, 164, 166 zusammengesetzt ist, wobei die Gitterflecken 162, 164 und 166 statistisch innerhalb des Strahlungsquerschnitts SQ des Strahlungsfeldes 40 verteilt angeordnet sein können oder beispielsweise regelmäßig angeordnet sind, wie dies in Fig. 19 dargestellt ist, wobei jeweils zwei Gitterflecken 162 sich in einer zur ersten Richtung 14 parallelen Reihenrichtung 172 angeordnet sind, Gitterflecken 164 in einer zur ersten Richtung 14 parallelen Reihenrichtung 174 und Gitterflecken 166 in einer zur ersten Richtung 14 parallelen Reihenrichtung 176 angeordnet sind, wobei die Gitterflecken 162, 164 und 166 längs der jeweiligen Reihenrichtung 172, 174 und 176 einen Abstand voneinander aufweisen.

Um möglichst einen hohen Anteil von Transversalmoden des Laserstrahlungsfeldes 20 im teilkollimierten Bereich 40 zu erfassen, sind die Gitterflecken 162, 164 und 166 allesamt so angeordnet, dass die Gitterflecken 162, 164 und 166 vorzugsweise verteilt über eine Ausdehnung SQ1 des Strahlungsquerschnitts SQ parallel zur ersten Richtung 14 Bereiche des Strahlungsquerschnitts SQ einkoppeln und zurückreflektieren.

Eine zweckmäßige Anordnung sieht hierbei vor, dass eine Projektion der Gitterflecken 162, 164 und 166 auf eine der Reihenrichtungen 172, 174 oder 176, wie in Fig. 18 dargestellt, dazu führt, dass die Gitterflecken 162, 164 und 166 parallel zur ersten Richtung über mindestens 80% der Ausdehnung SQ1 des Strahlungsquerschnitts SQ parallel zur ersten Richtung 14 verteilt angeordnet sind und somit innerhalb dieses Bereiches von 80% der Ausdehnung SQ1 in der Lage sind, Transversalmoden des Laserstrahlungsfeldes 20 im teilkollimierten Bereich 40 zu reflektieren.

Vorzugsweise sind die Gitterflecken 162, 164 und 166 so angeordnet, dass die bei einer Projektion auf eine der Reihenrichtungen 172, 174 und 176 entweder mit geringen Abständen voneinander angeordnet sind oder aneinander anschließen oder sogar noch in der jeweiligen Reihenrichtung 172, 174 oder 176 überlappen.

Der Vorteil dieses Ausführungsbeispiels ist darin zu sehen, dass damit die Möglichkeit besteht, die bedingt durch das resonante Wellenleitergitter entstehenden intensitätsfreien Bereiche des Laserstrahlungsfeldes 40 nicht als zusammenhängende Bereiche zu erhalten, sondern als verteilt angeordnete Bereiche, um insgesamt im Fernfeld die Strahlqualität möglichst wenig zu beeinträchtigen.

Dabei sind vorzugsweise die Gitterflecken 162, 164 und 166 als derart ausgebildete und aufgebaute resonante Wellenleitergitter 50' ausgeführt, wie sie beispielsweise im Zusammenhang mit dem ersten Ausführungsbeispiel beschrieben wurden.

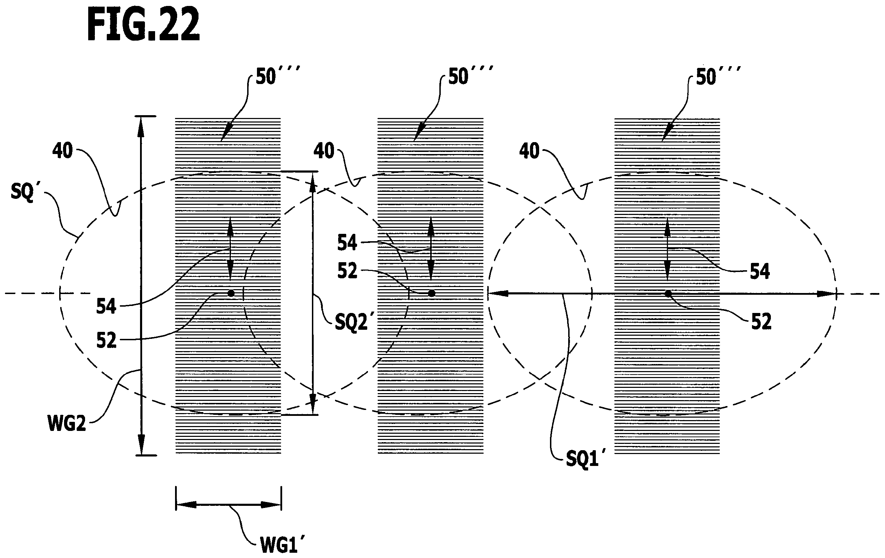

Bei einem achten Ausführungsbeispiel eines erfindungsgemäßen Lasersystems, dargestellt in Fig. 22, ist für jedes der kollimierten Laserstrahlungsfelder 40 ein resonantes Wellenleitergitter 50''' vorgesehen, das sich, im Gegensatz zu den Voranstehenden Ausführungsbeispielen mit seiner jeweiligen Längsrichtung 54 parallel zur zweiten Richtung 16 erstreckt und damit quer oder vorzugsweise senkrecht zur ersten Richtung 14.

Um eine ausreichende Zahl transversaler Moden zurückreflektieren zu können, ist die Ausdehnung WG1' des resonanten Wellenleitergitters 50''' so groß, dass diese mindestens 20% der Ausdehnung SQ1 des Strahlungsquerschnitts SQ in der ersten Richtung 16 beträgt.

Ferner hat das resonante Wellenleitergitter 50''' seinerseits eine Ausdehnung WG2 in der zweiten Richtung 16, die mindestens 80% der Ausdehnung SQ2' der Ausdehnung des Strahlungsquerschnitts SQ' in der zweiten Richtung beträgt.

Damit ist ein derart angeordnetes resonantes Wellenleitergitter 50'' parallel zur zweiten Richtung 16 polarisierte Laserstrahlungsfelder 20' zurückzureflektieren und dabei eine ausreichend große Zahl von Transversalmoden noch zu erfassen.

Im Übrigen arbeitet das achte Ausführungsbeispiel des erfindungsgemäßen Laserverstärkersystems in gleicher Weise wie die Voranstehenden Ausführungsbeispiele, so dass auf die Ausführungen zu diesen vollinhaltlich Bezug genommen werden kann.

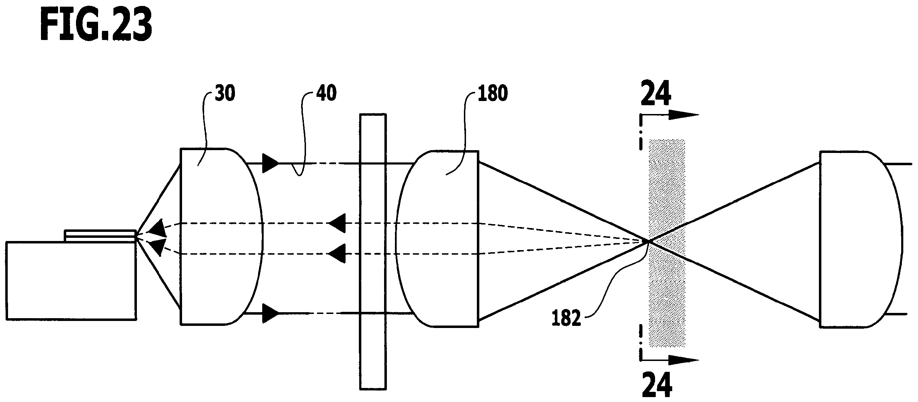

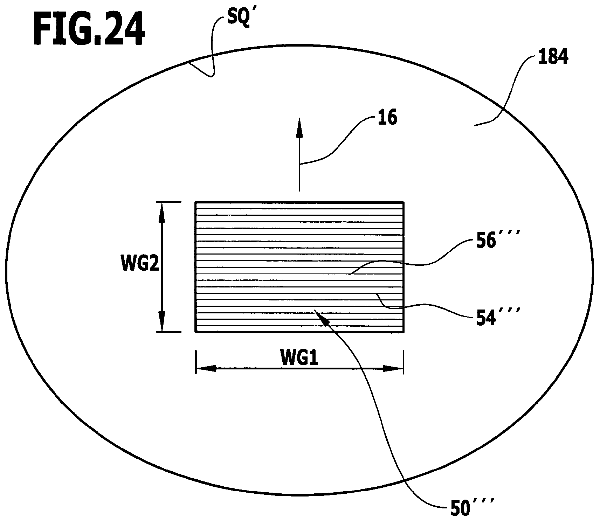

Bei einem neunten Ausführungsbeispiel eines erfindungsgemäßen Laserverstärkersystems, dargestellt in Fig. 23 und Fig. 24, wird der teilkollimierte Bereich 40 des Strahlungsfeldes 20 durch eine fokussierende Optik 180 mit einer längeren Brennweite als die kollimierende Optik 30 auf einen Zwischenfokusbereich 184 fokussiert und innerhalb dieses Zwischenfokusbereichs 184 ist ein resonantes Wellenleitergitter 50''' angeordnet, dessen Gitterstruktur 56''' quer zur zweiten Richtung 16 verlaufend ausgerichtete Strukturelemente 54''' aufweist, in gleicher Weise wie beim achten Ausführungsbeispiel.

Beispielsweise erstreckt sich das resonante Wellenleitergitter 50''' mit seiner Ausdehnung WG1 in der ersten Richtung ungefähr über dieselbe Distanz wie beim achten Ausführungsbeispiel, das heißt beispielsweise über mehr als 20%, jedoch mit seiner Ausdehnung WG2 in der zweiten Richtung 16 über maximal 30% eines Strahlungsquerschnitts SQ' im Fokusbereich 184.

Bei diesem Ausführungsbeispiel wird aufgrund des fokussierten Einfalls des Laserstrahlungsfeldes 20 auf das resonante Wellenleitergitter 50''' nur der Teil des einfallenden Laserstrahlungsfeldes 20 reflektiert, welcher innerhalb des im Zusammenhang mit dem ersten Ausführungsbeispiel erläuterten Bereichs der Winkelakzeptanz von ± 2° liegt, während der übrige Teil des Laserstrahlungsfeldes durch das resonante Wellenleitergitter 50''' hindurchtritt, so dass lediglich ein Bruchteil der Intensität des einfallenden Laserstrahlungsfeldes 20 durch das resonante Wellenleitergitter 50''' aufgrund der Einfallsrichtung des Laserstrahlungsfeldes 20 reflektiert wird.

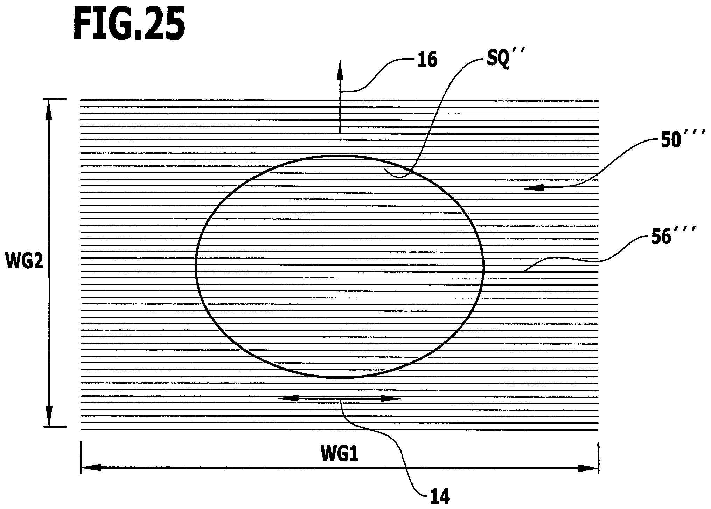

Daher ist es bei einem Beispiel zum besseren Verständnis der Erfindung auch möglich das Wellenleitergitter 50''' so groß auszuführen, dass der gesamte Strahlungsquerschnitt SQ'' im Fokusbereich auf das Wellenleitergitter 50''' trifft, wie in Fig. 25 dargestellt.

Bei allen auf das erste Ausführungsbeispiel folgenden Ausführungsbeispielen sind diejenigen Elemente, die mit denen eines der voranstehenden Ausführungsbeispiele identisch sind, mit denselben Bezugszeichen versehen, so dass hinsichtlich dieser Elemente jeweils auf die voranstehenden Ausführungsbeispiele Bezug genommen wird.

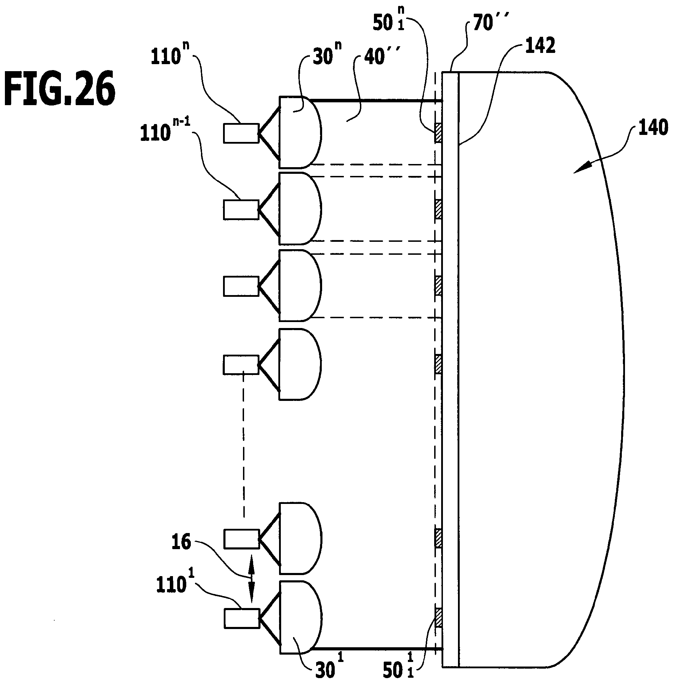

Bei einem elften Ausführungsbeispiel einer erfindungsgemäßen Lasersystems, dargestellt in Fig. 26, sind ähnlich wie beim vierten Ausführungsbeispiel eine Vielzahl von Laserbarren $110^1$ bis $110^n$ in Richtung der zweiten Richtung 16 übereinander gestapelt angeordnet und für jeden der Laserbarren 110 ist beispielsweise eine eigene kollimierende Optik $30^1$ bis $30^n$ vorgesehen, so dass die teilkollimierten Bereiche 40 der Laserstrahlungsfelder in der zweiten Richtung 16 alle teilkollimiert sind und auf ein für jeden einzelnen Halbleiterlaser 10 der Laserbarren 110 vorgesehenes Wellenleitergitter $50_1^1$ bis $50_n^n$ auftreffen, die beispielsweise auf einem gemeinsamen Substrat 70'' angeordnet sind, das seinerseits auf einer Rückseite 142 einer die teilkollimierten Bereiche 40'' der Laserstrahlungsfelder 20 gemeinsam fokussierenden Optik 140 angeordnet ist, so dass das Substrat 70'' durch die Optik 140 gehalten ist. Damit werden in jedem der Laserbarren 110 sämtliche einzelnen Halbleiterlaser $10_1$ bis $10_n$ durch das jeweilige resonante Wellenleitergitter $50_1^x$ bis $50_n^x$ einzeln extern stabilisierbar und es erfolgt keine Kopplung der teilkollimierten Bereiche 40 mit einem seitlich daneben liegenden, einem darüber liegenden oder einem darunter liegenden Halbleiterlaser 10.

Somit besteht die Möglichkeit, jeden einzelnen der Halbleiterlaser 10 auf einer ausgewählten Wellenlänge extern zu stabilisieren.

Beispielsweise könnten die Halbleiterlaser 10 eines Halbleiterlaserbarrens 110 auf derselben Wellenlänge extern stabilisiert sein und die Wellenlänge von Halbleiterlaserbarren $110^x$ zu Halbleiterlaserbarren $110^{x+1}$ oder $110^{x-1}$ variieren.

Eine besonders vorteilhafte Lösung sieht vor, dass jeder der Halbleiterlaser $10^x_x$ auf einer anderen Wellenlänge durch das entsprechende resonante Wellenleitergitter $50^x_x$ extern auf einer Wellenlänge stabilisiert ist, die sich von der Wellenlänge der anderen Halbleiterlaser $10^{x+y}_{x+y}$ unterscheidet.

Vorzugsweise sind die Halbleiterlaser $10^x_1$ bis $10^x_n$ jedes der Halbleiterlaserbarren $110^x$ aus demselben Material hergestellt, jedoch auf jeweils einer anderen Wellenlänge extern stabilisiert und die verschiedenen Halbleiterbarren 110 können aus unterschiedlichen Materialien hergestellt sein, so dass sich die Halbleiterlaser 10 in diesen Halbleiterlaserbarren 110 in verschiedenen Wellenlängenbereichen stabilisieren lassen.

**Patentansprüche**

1.  Lasersystem umfassend
    mindestens einen extern stabilisierbaren Halbleiterlaser (10), aus dessen laseraktiver Zone (11) ein Laserstrahlungsfeld (20) ausgekoppelt wird, ein extern im Laserstrahlungsfeld angeordnetes Rückkopplungselement (50, 120), welches ein einen innerhalb eines Winkelakzeptanzbereichs (WA) liegenden Teil des Laserstrahlungsfeldes (20) zurückreflektierendes Wellenleitergitter (50, 120) ist, wobei der Winkelakzeptanzbereich (WA) dem Winkelbereich entspricht, in welchem 95% der reflektierten Intensität von einer Strahlung, die von einer Normalen (80) einer zu einer Reihenrichtung (76) parallelen Ebene abweichend auf das Wellenleitergitter (50) einfällt, liegen, und welches aus dem Laserstrahlungsfeld (20) ein Rückkopplungsstrahlungsfeld (42) mit definierter Wellenlänge und Bandbreite auskoppelt und in die laseraktive Zone (11) zur Festlegung von Wellenlänge und Bandbreite des Laserstrahlungsfeldes (20) zurückkoppelt, wobei das resonante Wellenleitergitter (50) in seinem Bereich in der Größenordnung von 100% der Intensität des auf das Wellenleitergitter (50) einfallenden Anteils des Laserstrahlungsfeldes (20) zurückreflektiert, und eine Ausdehnung des resonanten Wellenleitergitters (50) so dimensioniert ist, dass das resonante Wellenleitergitter (50) einen Anteil im Bereich von 5% bis 30% der Intensität des gesamten Laserstrahlungsfeldes (20) als Rücckopplungsstrahlungsfeld (42) in Richtung zu dem Halbleiterlaser (10) zurückreflektiert, und die nicht von dem resonanten Wellenleitergitter (50) zurückreflektierte Intensität des Laserstrahlungsfeldes (20) in Form eines Austrittsstrahlungsfeldes (60) zur Verfügung steht,
    wobei das Rückkopplungselement ein resonantes Wellenleitergitter (50, 120) mit einer Oberflächenstruktur (72) ist, welche über einer Basisfläche (74) in der Reihenrichtung (76) aufeinanderfolgende Erhebungen (78) aufweist, wobei die Ausdehnung (E) der Erhebungen (78) in der Reihenrichtung (76) sowie eines Abstandes (A) zwischen den Erhebungen mindestens eine zweifache Periodizität aufweist, wobei das resonante Wellenleitergitter (50, 120) aus mindestens drei Wellenleiterschichten (82, 84, 86) aufgebaut ist, einer obersten Wellenleiterschicht (86) mit hohem Brechungsindex, einer darunterliegenden Wellenleiterschicht (84) mit niedrigem Brechungsindex, wobei sich der hohe Berechnungsindex und der niedrige Berechnungsindex um mindestens 0,2 unterscheiden, und einer der obersten Wellenleiterschicht (86) gegenüberliegende Wellenleiterschicht (82) mit hohem Brechungsindex.

2.  Lasersystem nach einem der voranstehenden Ansprüche, **dadurch gekennzeichnet, dass** das resonante Wellenleitergitter (50, 120) auf dem Substrat (70) aufgetragene Wellenleiterschichten (82, 84, 86) aufweist, dass eine Gitterstruktur (56) durch eine die Wellenleiterschichten (82, 84, 86) tragende Substratoberfläche (70) vorgegeben ist oder durch eine dem Substrat (70') abgewandte oberste Wellenleiterschicht (86') vorgegeben ist.

3.  Lasersystem nach einem der voranstehenden Ansprüche, **dadurch gekennzeichnet, dass** das resonante Wellenleitergitter (50, 120) ein einfallendes Laserstrahlungsfeld (20) teilweise in einer Wellenausbreitungsrichtung (76, 96) versetzt zurückreflektiert und dass insbesondere das resonante Wellenleitergitter (50, 120) eine Wellenausbreitungsrichtung (76) aufweist, die parallel zu einer Reihenrichtung (112) verläuft, in welcher quer zur Reihenrichtung verlaufende Erhebungen des resonanten Wellenleitergitters aufeinanderfolgend angeordnet sind.

4.  Lasersystem nach einem der voranstehenden Ansprüche, **dadurch gekennzeichnet, dass** das resonante Wellenleitergitter (50, 120) gekühlt ist und dass insbesondere das resonante Wellenleitergitter (50, 120) auf einer für das Laserstrahlungsfeld transparenten Wärmesenke (150) angeordnet ist.

5. Lasersystem nach einem der voranstehenden Ansprüche, **dadurch gekennzeichnet, dass** das resonante Wellenleitergitter (50, 120) in einem zumindest teilkollimierten Bereich (40) des Laserstrahlungsfeldes (20) angeordnet ist.

6. Lasersystem nach einem der Ansprüche 1 bis 4, **dadurch gekennzeichnet, dass** das resonante Wellenleitergitter (50''') in einem fokussierten Abschnitt des Laserstrahlungsfelds (20) angeordnet ist.

7. Lasersystem nach einem der voranstehenden Ansprüche, **dadurch gekennzeichnet, dass** das resonante Wellenleitergitter (50, 120) in einem Teilbereich des Strahlungsquerschnitts (SQ) des Laserstrahlungsfeldes (20) angeordnet ist.

8. Lasersystem nach einem der voranstehenden Ansprüche, **dadurch gekennzeichnet, dass** das resonante Wellenleitergitter (50, 120) sich in einer Reihenrichtung, in welcher quer zur Reihenrichtung verlaufende Erhebungen des resonanten Wellenleitergitters aufeinanderfolgend angeordnet sind, in einem Strahlungsquerschnitt (SQ) des Laserstrahlungsfeldes (20) erstreckt.

9. Lasersystem nach Anspruch 7, **dadurch gekennzeichnet, dass** das resonante Wellenleitergitter (120) sich in einer Reihenrichtung, in welcher quer zur Reihenrichtung verlaufende Erhebungen des resonanten Wellenleitergitters aufeinanderfolgend angeordnet sind, innerhalb von mindestens zwei nebeneinanderliegenden Strahlungsquerschnitten (SQ) von nebeneinanderliegenden Laserstrahlungsfeldern (20) erstreckt.

10. Lasersystem nach einem der Ansprüche 1 bis 8, **dadurch gekennzeichnet, dass** das resonante Wellenleitergitter (50'') innerhalb des jeweiligen Strahlungsquerschnitts (SQ) verteilt angeordnete Gitterflecken (162, 164, 166) aufweist, die nicht zusammenhängende einzelne Wellenleitergitterteile darstellen.

11. Lasersystem nach einem der voranstehenden Ansprüche, **dadurch gekennzeichnet, dass** die extern stabilisierbaren Halbleiterlaser (10) in einer Reihenrichtung (112), in welcher quer zu der Reihenrichtung (112) verlaufende Erhebungen des resonanten Wellenleitergitters aufeinanderfolgend angeordnet sind, aufeinanderfolgend angeordnet sind und dass insbesondere die Halbleiterlaser (10) in einer quer zur Reihenrichtung (112) verlaufenden Stapelrichtung aufeinanderfolgend angeordnet sind.

12. Lasersystem nach einem der voranstehenden Ansprüche, **dadurch gekennzeichnet, dass** das Lasersystem mehrere in einem Halbleiterlaserbarren (110) in der Reihenrichtung (112), in welcher quer zu der Reihenrichtung (112) verlaufende Erhebungen des resonanten Wellenleitergitters aufeinanderfolgend angeordnet sind, aufeinanderfolgend angeordnete, extern stabilisierbare Halbleiterlaser (10) aufweist und dass insbesondere die Laserstrahlungsfelder (20) in einer ersten Richtung (14) parallel zu der Reihenrichtung (112) die kleine Divergenz aufweisen.

13. Lasersystem nach Anspruch 12, **dadurch gekennzeichnet, dass** die in der Reihenrichtung (112) aufeinanderfolgenden Halbleiterlaser (10) Laserstrahlungsfelder (20) erzeugen, die in einer parallel zur Reihenrichtung (112) verlaufenden Richtung (114) aufeinanderfolgend angeordnete Strahlungsquerschnitte (SQ) aufweisen und dass insbesondere sich das streifenförmig ausgebildete resonante Wellenleitergitter (120) parallel zur Reihenrichtung (112) innerhalb von mindestens zwei Strahlungsquerschnitten (SQ) erstreckt.

14. Lasersystem nach Anspruch 13, **dadurch gekennzeichnet, dass** das resonante Wellenleitergitter (120) in Richtung parallel zur Reihenrichtung (112) einen durch alle Laserstrahlungsfelder (20) des Halbleiterlaserbarrens (110) verlaufenden Streifen bildet.

15. Lasersystem nach einem der Ansprüche 12 bis 14, **dadurch gekennzeichnet, dass** mehrere Halbleiterlaserbarren (10) vorgesehen sind, dass in jedem der Halbleiterlaserbarren (110) die Halbleiterlaser (10) aus demselben Material hergestellt sind, dass insbesondere in unterschiedlichen Halbleiterlaserbarren (110) die Halbleiterlaser (10) aus unterschiedlichem Material hergestellt sind.

16. Lasersystem nach einem der Ansprüche 1 bis 15, **dadurch gekennzeichnet, dass** die Halbleiterlaser (10) bei verschiedenen Wellenlängen durch das Rückkopplungsstrahlungsfeld (42) mit definierter Wellenlänge extern stabilisiert sind.

**Claims**

1. Laser system comprising
at least one externally stabilizable semiconductor laser (10) from the active laser zone (11) of which a laser radiation field (20) can be emitted, and
a feedback element (50, 120),
which is disposed externally in the laser radiation field,
which is a waveguide grating (50, 120) which reflects back a portion of the laser radiation field (20) lying within an angular acceptance range (WA), the angular acceptance range (WA) corresponding to the angular range in which there is present 95% of the reflected intensity of a radiation which is incident on the waveguide grating (50) and deviates from a normal (80) to a plane which is parallel to a row direction (76), and which produces, from the laser radiation field (20), a feedback radiation field (42) having a defined wavelength and bandwidth, and feeds same into the active laser zone (11) for determining the wavelength and bandwidth of the laser radiation field (20),

the resonant waveguide grating (50) reflecting back approximately 100% of the intensity, in its area, of the portion of the laser radiation field (20) which is incident on the waveguide grating (50), and an extent of the resonant waveguide grating (50) having dimensions such that the resonant waveguide grating (50) reflects back a portion of the intensity of the entire laser radiation field (20), in the range of 5% to 30%, as a feedback radiation field (42) in the direction of the semiconductor laser (10), and

the intensity of the laser radiation field (20) which is not back-reflected by the resonant waveguide grating (50), being available in the form of an exiting radiation field (60),

the feedback element being a resonant waveguide grating (50, 120) having a surface structure (72) which has elevations (78) above a base surface (74) that follow one after the other in the row direction (76), the extent (E) of the elevations (78) in the row direction (76), as well as a distance (A) between the elevations, having at least a double periodicity, the resonant waveguide grating (50, 120) being composed of at least three waveguide layers (82, 84, 86): a topmost waveguide layer (86) having a high index of refraction, a waveguide layer (84) therebeneath having a low index of refraction, the difference between the high index of refraction and the low index of refraction being at least 0.2, and a waveguide layer (82), situated opposite from the topmost waveguide layer (86), having a high index of refraction.

2. Laser system according to Claim 1, **characterized in that** the resonant waveguide grating (50, 120) has waveguide layers (82, 84, 86) applied to the substrate (70), and that a grating structure (56) is specified by a substrate surface (70) which carries the waveguide layers (82, 84, 86) or by a topmost waveguide layer (86') facing away from the substrate (70').

3. Laser system according to either of the preceding claims, **characterized in that** the resonant waveguide grating (50, 120) partially back-reflects an incident laser radiation field (20), offset in a wavelength propagation direction (76, 96), and that in particular the resonant waveguide grating (50, 120) has a wavelength propagation direction (76) which extends parallel to a row direction (112) in which elevations of the resonant waveguide grating are situated one after the other, the elevations extending transversely with respect to the row direction.

4. Laser system according to any of the preceding claims, **characterized in that** the resonant waveguide grating (50, 120) is cooled, and that in particular the resonant waveguide grating (50, 120) is situated on a heat sink (150) that is transparent to the laser radiation field.

5. Laser system according to any of the preceding claims, **characterized in that** the resonant waveguide grating (50, 120) is situated in an at least partially collimated region (40) of the laser radiation field (20).

6. Laser system according to any of Claims 1 to 4, **characterized in that** the resonant waveguide grating (50''') is situated in a focused portion of the laser radiation field (20).

7. Laser system according to any of the preceding claims, **characterized in that** the resonant waveguide grating (50, 120) is situated in a subarea of the radiation cross-section (SQ) of the laser radiation field (20).

8. Laser system according to any of the preceding claims, **characterized in that** the resonant waveguide grating (50, 120) extends, in a radiation cross-section (SQ) of the laser radiation field (20), in a row direction in which elevations of the resonant waveguide grating are situated one after the other, the elevations extending transversely with respect to the row direction.

9. Laser system according to Claim 7, **characterized in that** the resonant waveguide grating (120) extends, within at least two adjacently situated radiation cross-sections (SQ) of adjacently situated laser radiation fields (20), in a row direction in which elevations of the resonant waveguide grating are situated one after the other, the elevations extending transversely with respect to the row direction.

10. Laser system according to any of Claims 1 to 8, **characterized in that** the resonant waveguide grating (50") has grating patches (162, 164, 166), which are distributed within the particular radiation cross-section (SQ) and form noncontiguous individual waveguide grating parts.

11. Laser system according to any of the preceding claims, **characterized in that** the externally stabilizable semiconductor lasers (10) are situated one after the other in a row direction (112) in which elevations of the resonant waveguide grating (112) are situated one after the other, the elevations extending transversely with respect to the row direction, and that in particular the semiconductor lasers (10) are situated one after the other in a stacking direction which extends transversely with respect to the row direction (112).

**12.** Laser system according to any of the preceding claims, **characterized in that** the laser system has a plurality of externally stabilizable semiconductor lasers (10) situated one after the other in a semiconductor laser bar (110) in the row direction (112) in which elevations of the resonant waveguide grating (112) are situated one after the other, the elevations extending transversely with respect to the row direction, and that in particular the laser radiation fields (20) have low divergence in a first direction (14) parallel to the row direction (112).

**13.** Laser system according to Claim 12, **characterized in that** the semiconductor lasers (10) situated one after the other in the row direction (112) generate laser radiation fields (20) which have radiation cross-sections (SQ) situated one after the other in a direction (114) extending parallel to the row direction (112), and that in particular the strip-shaped resonant waveguide grating (120) extends parallel to the row direction (112) within at least two radiation cross-sections (SQ).

**14.** Laser system according to Claim 13, **characterized in that** the resonant waveguide grating (120) forms a strip that extends through all laser radiation fields (20) of the semiconductor laser bar (110) in the direction parallel to the row direction (112).

**15.** Laser system according to any of Claims 12 to 14, **characterized in that** a plurality of semiconductor laser bars (10) are provided, that the semiconductor lasers (10) are made of the same material in each of the semiconductor laser bars (110), and that in particular the semiconductor lasers (10) are made of different materials in different semiconductor laser bars (110).

**16.** Laser system according to any of Claims 1 to 15, **characterized in that** the semiconductor lasers (10) are externally stabilized at different wavelengths by the feedback radiation field (42) that has a defined wavelength.

## Revendications

**1.** Système laser comprenant
au moins un laser à semi-conducteur (10) stabilisable en externe, de la zone à effet laser (11) duquel un champ de rayonnement laser (20) est découplé, un élément de rétrocouplage (50, 120), qui est disposé à l'extérieur dans le champ de rayonnement laser et qui est un réseau de guide d'onde (150, 120) réfléchissant une partie du champ de rayonnement laser (20) située à l'intérieur d'une plage d'acceptation angulaire (WA), la plage d'acceptation angulaire (WA) correspondant à la plage angulaire, dans laquelle se trouvent 95 % de l'intensité réfléchie par un rayonnement frappant le réseau de guide d'onde (50) en s'écartant d'une normale (80) d'un plan parallèle à une direction d'alignement (76) et qui découple du champ de rayonnement laser (20) un champ de rayonnement de rétrocouplage (42) ayant une longueur d'onde et une largeur de bande définies et le rétro-couple dans la zone à effet laser (11) afin de fixer la longueur d'onde et la largeur de bande du champ de rayonnement laser (50), le réseau de guide d'onde résonant (50) rétroréfléchisant dans sa plage dans un ordre de grandeur de 100 % de l'intensité de la fraction du champ de rayonnement laser (20) frappant le réseau de guide d'onde (50), et une étendue du réseau de guide d'onde résonant (50) étant dimensionnée de manière à ce que le réseau de guide d'onde résonant (50) rétroréfléchisse une fraction dans la plage de 5 % à 30 % de l'intensité du champ de rayonnement laser (20) total en tant que champ de rayonnement de rétrocouplage (42) en direction du laser à semi-conducteur (10), et l'intensité du champ de rayonnement laser (50), qui n'est pas rétroréfléchie par le réseau de guide d'onde résonant (50), est disponible sous la forme d'un champ de rayonnement de sortie (60),
l'élément de rétrocouplage étant un réseau de guide d'onde résonant (50, 120) ayant une structure superficielle (72) présentant des élévations (78) successives dans la direction d'alignement (76) au-dessus d'une surface de base (74), l'extension (E) des élévations (78) dans la direction d'alignement (76) ainsi que d'une distance (A) entre les élévations, présentant une double périodicité, le réseau de guide d'onde résonant (50, 120) étant constitué d'au moins trois couches de guide d'onde (82, 84, 86), une couche de guide d'onde supérieure (86) ayant un indice de réfraction élevé, une couche de guide d'onde (84) située en dessous de celle-ci ayant un indice de réfraction bas, l'indice de réfraction élevé et l'indice de réfraction bas étant différents d'au moins 0,2, et une couche de guide d'onde (82) ayant un indice de réfraction élevé située en face de la couche de guide d'onde supérieure (86).

**2.** Système laser selon l'une quelconque des revendications précédentes, **caractérisé en ce que** le réseau de guide d'onde résonant (50, 120) présente des couches de guide d'onde (82, 84, 86) appliquées sur le substrat, **en ce qu'**une structure en réseau (56) est prédéfinie par une surface de substrat (70) portant les couches de guide d'onde (82, 84, 86) ou par une couche de guide d'onde (86') supérieure éloignée du substrat (70').

**3.** Système laser selon l'une quelconque des revendications précédentes, **caractérisé en ce que** le réseau de guide d'onde résonant (50, 120) rétro-réfléchit de manière décalée un champ de rayonnement laser incident (20) en partie dans une direction de propagation des ondes (76, 96), et **en ce que** notamment le réseau de guide d'onde résonant (50, 120) présente une direction de propagation des ondes (76, 96) parallèle à une direction d'alignement (112) dans laquelle sont disposées successivement des élévations, transversales à la direction d'alignement, du réseau de guide d'onde résonant.

**4.** Système laser selon l'une quelconque des revendications précédentes, **caractérisé en ce que** le réseau de guide d'onde résonant (50, 120) est refroidi et **en ce que** notamment le réseau de guide d'onde résonant (50, 120) est disposé sur un puits de chaleur (150) transparent pour le champ de rayonnement laser.

**5.** Système laser selon l'une quelconque des revendications précédentes, **caractérisé en ce que** le réseau de guide d'onde résonant (50, 120) est disposé dans une zone (40), au moins partiellement collimatée, du champ de rayonnement laser (20).

**6.** Système laser selon l'une quelconque des revendications 1 à 4, **caractérisé en ce que** le réseau de guide d'onde résonant (50''') est disposé dans un tronçon concentré du champ de rayonnement laser (20).

**7.** Système laser selon l'une quelconque des revendications précédentes, **caractérisé en ce que** le réseau de guide d'onde résonant (50, 120) est disposé dans une zone partielle de la section transversale de rayonnement (SQ) du champ de rayonnement laser (20).

**8.** Système laser selon l'une quelconque des revendications précédentes, **caractérisé en ce que** le réseau de guide d'onde résonant (50, 120) s'étend dans une direction d'alignement, dans laquelle sont disposées successivement des élévations, transversales à la direction d'alignement, du réseau de guide d'onde résonant, dans une section transversale de rayonnement (SQ) du champ de rayonnement laser (20).

**9.** Système laser selon la revendication 7, **caractérisé en ce que** le réseau de guide d'onde résonant (120) s'étend dans une direction d'alignement, dans laquelle sont disposées successivement des élévations, transversales à la direction d'alignement, du réseau de guide d'onde résonant, à l'intérieur d'au moins deux sections de rayonnement transversales adjacentes (SQ) de champs de rayonnement laser adjacents (20).

**10.** Système laser selon l'une quelconque des revendications 1 à 8, **caractérisé en ce que** le réseau de guide d'onde résonant (50'') présente des taches de réseau (162, 164, 166), qui sont réparties à l'intérieur de la section de rayonnement (SQ) respective et qui constituent des parties de réseau de guide d'onde non cohérentes.

**11.** Système laser selon l'une quelconque des revendications précédentes, **caractérisé en ce que** les lasers à semi-conducteur stabilisable en externe (10) sont disposés successivement dans une direction d'alignement (112) dans laquelle sont disposées successivement des élévations transversales à la direction d'alignement (112), du réseau de guide d'onde résonant, et **en ce que** notamment les lasers à semi-conducteur (10) sont disposés successivement dans un sens d'empilement transversal à la direction d'alignement (112).

**12.** Système laser selon l'une quelconque des revendications précédentes, **caractérisé en ce que** le système laser présente plusieurs lasers à semi-conducteur stabilisable en externe (10) disposés successivement dans une barre de lasers à semi-conducteur (110) dans la direction d'alignement (112) dans laquelle sont disposées successivement des élévations, transversales à la direction d'alignement (112), du réseau de guide d'onde résonant, et **en ce que** notamment les champs de rayonnement laser (20) présentent la petite divergence dans une première direction (14) parallèle à la direction d'alignement (112) .

**13.** Système laser selon la revendication 12, **caractérisé en ce que** les lasers à semi-conducteur (10) se succédant dans la direction d'alignement (112) génèrent des champs de rayonnement laser présentant des sections transversales de rayonnement (SQ) disposées successivement dans une direction (114) parallèle à la direction d'alignement (112), et **en ce que** notamment le réseau de guide d'onde résonant (120), en forme de bande, est parallèle à la direction d'alignement (112) à l'intérieur d'au moins deux sections transversales de rayonnement (SQ).

**14.** Système laser selon la revendication 13, **caractérisé en ce que** le réseau de guide d'onde résonant (120) forme, dans la direction parallèle à la direction d'alignement (112), une bande traversant tous les champs de rayonnement laser (20) de la barre de lasers à semi-conducteur (110).

15. Système laser selon l'une quelconque des revendications 12 à 14, **caractérisé en ce que** plusieurs barres de lasers à semi-conducteur (10) sont prévues, **en ce que**, dans chacune des barres de lasers à semi-conducteur (110), les lasers à semi-conducteur (10) sont fabriqués dans la même matière, **en ce que** notamment dans des barres différentes de lasers à semi-conducteur (110) les lasers à semi-conducteur (10) sont fabriqués dans une matière différente.

16. Système laser selon l'une quelconque des revendications 1 à 15, **caractérisé en ce que** les lasers à semi-conducteur (10) sont stabilisés en externe, en cas de longueurs d'ondes différentes, par le champ de rayonnement de rétrocouplage (42) d'une longueur d'onde définie.

FIG.1

FIG.2

# FIG.3

EP 2 550 710 B1

FIG.4

# FIG.7

Wavelength nm

WAe

# FIG.6

AngleN deg

WAm

EP 2 550 710 B1

# FIG.5

# FIG.8

EP 2 550 710 B1

# FIG.9

EP 2 550 710 B1

EP 2 550 710 B1

# FIG.10

# FIG.11

EP 2 550 710 B1

# FIG.12

EP 2 550 710 B1

# FIG.13

EP 2 550 710 B1

# FIG.14

FIG.15

EP 2 550 710 B1

FIG.16

EP 2 550 710 B1

**FIG.17**

EP 2 550 710 B1

EP 2 550 710 B1

# FIG.18

**FIG.19**

**FIG.20**

FIG.21

EP 2 550 710 B1

# FIG.22

EP 2 550 710 B1

FIG.23

EP 2 550 710 B1

FIG.24

# FIG.25

EP 2 550 710 B1

FIG.26

**EP 2 550 710 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0709938 A2
- US 4719635 A1
- WO 02101895 A2

**In der Beschreibung aufgeführte Nicht-Patentliteratur**

- **B.L. VOLADIN.** *OPTICS LETTERS,* 15. August 2004, vol. 29 (16), 1891-1893
- **A. AVRUTSKII.** *Sov. I. Quantum Electron.,* August 1986, vol. 16 (8), 1063-1065
- **SENTENAC.** *JOSA A,* 2005, vol. 22, 475